# EUROPEAN PATENT APPLICATION

(11) **EP 2 945 233 A2**
(43) Date of publication of application: **18.11.2015**
(21) Application number: 15001413.2
(22) Date of filing: 12.05.2015
(51) Int. Cl.: H01S 5/14, H01S 5/065, H01S 5/40

(54) **WAVELENGTH STABILIZATION AND LINEWIDTH NARROWING FOR SINGLE MODE AND MULTIMODE LASER DIODES**

(30) Priority: 12.05.2014 IL 23258114
(71) Applicant: V-GEN LTD., 6744326 Tel Aviv (IL)
(72) Inventor: Inbar, Eran, 6523417 Tel Aviv (IL)
(74) Representative: Schuhmann, Albrecht

(57) **Abstract**

System for wavelength stabilization in a multimode (MM) laser diode (LD), including at least one MM LD, a respective at least one MM 2X2 beam splitter for each MM LD, an isolator and at least one LD, the LD being respectively coupled with the isolator, the MM LD for generating high power MM laser light, the isolator for enabling laser light to pass through in only one direction and the LD for generating low power laser light, each respective MM 2X2 beam splitter including four ports, each respective MM 2X2 beam splitter having a highly asymmetric splitting ratio and for splitting the generated high power MM laser light and the generated low power laser light, each MM LD being respectively coupled with the fourth port of each respective MM 2X2 beam splitter and a wavelength of the high power laser light locking onto a wavelength of the low power laser light.

## Description

### FIELD OF THE DISCLOSED TECHNIQUE

The disclosed technique relates to wavelength stabilization and linewidth narrowing, in general, and to methods and systems for stabilizing the wavelength and narrowing the linewidth of single mode and multimode diode lasers, in particular.

### BACKGROUND OF THE DISCLOSED TECHNIQUE

Laser diodes (herein abbreviated LDs) are lasers in which the gain medium is a semiconductor p-n junction. LDs are known for their low cost, high efficiency and small form factor. A typical packaged LD may measure just a few millimeters in size. These characteristics have made them a preferred choice of light source in diverse applications, such as range finding, remote sensing, optical media reading and writing (for example CDs and DVDs), printing and many more. Their applications encompass many fields of industry, such as telecommunications, material processing, medical devices and aerospace.

The characteristics of the laser light emitted by LDs are influenced by a number of factors, such as their design and manufacturing parameters as well as the operational conditions in which they are used. Design and manufacturing parameters can include, for example, the choice of semiconductor material and its amount of doping as well as the laser cavity length and finesse. The characteristics of laser light emitted by LDs can include its emission spectrum, its temporal profile and its transverse profile.

The emission spectrum refers to the range of wavelengths an LD can emit and is primarily determined according to the semiconductor material and dopant used in constructing the LD. LDs can be made to emit light ranging from the ultraviolet (herein abbreviated UV) to the near infrared (herein abbreviated NIR) range, spanning wavelengths of approximately 340 nanometers (herein abbreviated nm) to 1650 nm. In general, the emission spectrum of a given LD usually extends over a finite range of wavelengths, depending on factors such as temperature, current, and laser dynamics.

The emission spectrum of an LD can itself be characterized by a number of parameters, such as its linewidth and its wavelength stability. The linewidth of an emission spectrum for an LD refers to the range of wavelengths which are simultaneously emitted by the LD. The linewidth may exhibit a central or dominant wavelength which is emitted at a higher intensity from the LD. The wavelength stability of an emission spectrum for an LD refers to the susceptibility of the central or dominant wavelength to change over time. In comparison to solid state lasers, LDs tend to have a wide linewidth (usually on the order of a few nm) and are spectrally unstable unless steps are taken to stabilize them.

The temporal profile refers to how a beam of light is emitted by an LD over time. LDs can operate in a continuous wave (herein abbreviated CW) mode or in a pulsed mode, depending on the requirements of a specific laser application. In a pulsed mode, the pulse duration of the laser light emitted may be as short as a few picoseconds (10⁻¹² seconds). It is noted that the temporal profile of light emitted from an LD may be dictated by the driving electronics of the LD. In general, LDs operated in a CW mode will have a narrower linewidth than LDs operated in a pulsed mode due to the steady state of operation of LDs in a CW mode.

The transverse profile refers to the propagation mode in which a beam of light is emitted from an LD. The transverse profile can be categorized as either Single Mode (herein abbreviated SM) where only the fundamental transverse mode of the laser cavity is generated efficiently, or as Multi-Mode, or multimode (herein abbreviated MM) where a large number of modes are present in the emitted beam of light. In many laser applications, SM operation is usually preferable over MM operation, since a SM beam can be more tightly focused than a MM beam. However, it is difficult to sustain SM operation at high output powers (for example, output powers larger than a few tens of milliwatts), thereby making high power (for example, up to tens of watts) MM LDs a necessary compromise.

Light is directed away from an LD by coupling the LD to an optical fiber (also known as simply a fiber) which is usually coupled with a fiber pigtail. The optical fiber, similar to the laser, can be designed to support different transverse profiles, where a SM fiber can support a single propagation modes and a MM fiber can support multiple propagation modes. A third type of optical fiber, called a Large Mode Area (herein abbreviated LMA) fiber, represents a compromise in optical fiber design, where a few modes, but not many, are supported. LMA fibers increase the effective area of the fundamental mode. Usually, SM LDs are coupled to SM optical fibers and MM LDs are coupled to MM optical fibers.

When particular wavelengths are to be generated by lasers, then techniques, generally known as wavelength stabilization techniques, are used to stabilize the wavelength generated by the laser. In the case of laser diodes, prior art methods for wavelength stabilizing SM and MM laser diodes are known. Such prior art methods usually involve providing feedback to the laser diode from a stable wavelength source or element, such as a fiber Bragg grating (herein abbreviated FBG), or a volume Bragg grating (herein abbreviated VBG).

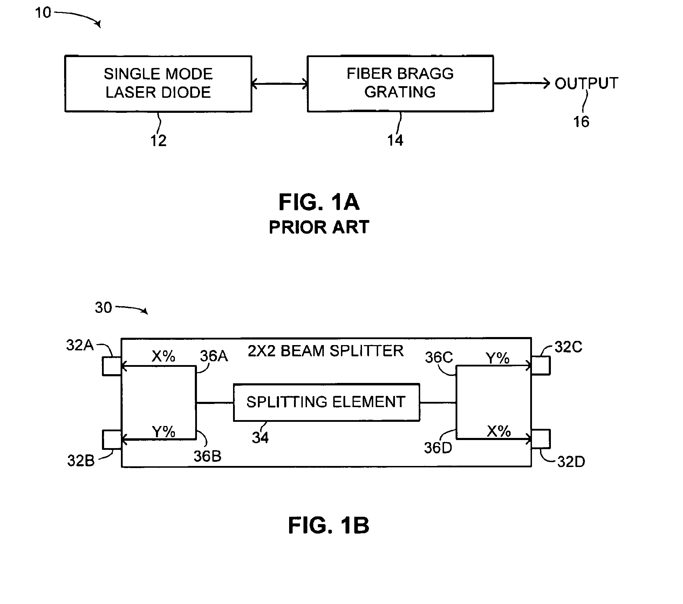

Reference is now made to Figure 1, which is a schematic illustration of a prior art wavelength stabilization system, generally referenced 10, showing how wavelength stabilization is enabled in a SM laser diode. Figure 1 includes a single mode (SM) laser diode (LD) 12, a fiber Bragg grating (FBG) 14 and an output laser beam, numbered 16. SM laser diode 12 is coupled with FBG 14, from which output laser beam 16 is emitted. Each of SM laser diode 12 and FBG 14 are coupled via optical fibers. FBG 14 is essentially an optical fiber that has been treated so that conditions (for example, its refractive index and its cladding shape) along a segment of the optical fiber are periodically modulated. The result of this treatment is that FBG 14 will have a non-zero reflectivity for light only in a well defined wavelength range. This wavelength range is known as the reflection band and is determined by the modulation period of the above mentioned conditions along the segment of the optical fiber. The center of the reflection band is known as the central wavelength of an FBG and its peak reflectivity is referred to as the reflectivity of an FBG. The reflectivity of an FBG can range from a few percents to one hundred percent depending on the length of the grating and its modulation depth. In wavelength stabilization applications, the desired properties of FBGs are a narrow reflection band, a small reflectivity, and a low sensitivity to thermal and mechanical fluctuations. If an FBG is constructed in a MM fiber, it will reflect the same wavelength for each propagation mode inside the fiber. However, when the beam of light exits the fiber, each of these modes will have a different wavelength depending on the modal dispersion of the fiber, thereby resulting in an increase in linewidth. A known solution to this problem is to use a volume Bragg grating (VBG), which is similar to a FBG but constructed from bulk glass instead of an optical fiber. While VBGs allow for wavelength stabilization of MM LDs, they are costly and require cumbersome free-space optical alignment.

In Figure 1, SM LD 12 emits light with a broad spectrum, an unstable spectrum or both. The light then passes through FBG 14 which reflects only the wavelengths of light lying in its reflection band. The rest of the light passes there through as output laser beam 16. The light reflected from FBG 14 back into the cavity (not shown) of SM LD 12 generates positive feedback for only those wavelengths. In this manner SM LD 12 locks onto the central wavelength and linewidth defined by the reflection band of FBG 14, thus resulting in wavelength stabilization and/or linewidth narrowing of output laser beam 16.

The setup shown in Figure 1 works well when SM LD 12 is operated in a CW mode. If SM LD 12 is operated in a pulsed mode, then timing effects must be taken into account when setting up wavelength stabilization system 10. As mentioned above, to enable wavelength locking, SM LD 12 must receive feedback from FBG 14. As it takes a finite amount of time for light to travel from SM LD 12 to FBG 14 and back, there is a delay between the beginning of a transmitted pulse, when SM LD 12 is switched on, and when a feedback signal from FBG 14 is provided back to SM LD 12 and begins to take effect. As an example, to achieve a roundtrip time of 1 nanosecond, the distance between SM LD 12 and FBG 14 should be approximately 10 centimeters. In this case wavelength stabilization will only be effective for pulses longer than a few nanoseconds, thus limiting the system shown in Figure 1 when very short pulses are required in a laser application. One possible solution to achieve wavelength stabilization at very short pulse durations is to place FBG 14 closer to SM LD 12, although such a solution itself creates several technical problems. One of them is that FBG 14 may be affected by any heat dissipated from SM LD 12. Heat from SM LD 12 may lead to thermal fluctuations of the central wavelength of FBG 14. Whereas this technical problem can be solved by coupling FBG 14 to an active temperature controller (not shown), this solution increases the cost and complexity of wavelength stabilization system 10. Another possible solution is to embed FBG 14 inside the structure (not shown) of SM LD 12 and thus share the temperature controller (not shown) built-in to the structure. This other solution also leads to a higher cost for the system as well as power limitations on SM LD 12.

In the case that SM laser diode 12 is operated as an MM laser diode (not shown), other problems arise in wavelength stabilizing the MM laser diode. As mentioned above, the setup shown in Figure 1 with an FBG can function properly, either in a CW mode or a pulsed mode when the optical fibers coupling the components of the system of Figure 1 are SM optical fibers. If SM LD 12 is embodied as a MM LD, then MM optical fibers need to be used to couple the components of Figure 1. As mentioned above, an FBG constructed on MM optical fibers does not lead to effective wavelength locking. A possible solution is to remove or terminate an output fiber (not shown) from the MM LD, collimate the emitted laser light (not shown) and pass it through a VBG (not shown), and then couple it back to a MM fiber (not shown). This solution involves an increase in the cost of the components as well as an increase in complexity in aligning and packaging such a system.

Other solutions for wavelength stabilizing SM and MM laser diodes are known in the art. US Patent Application Publication No. 2008/0267246 A1 to Volodin et al., entitled "Apparatus and method for altering a characteristic of a light-emitting device" is directed to an apparatus for altering one or more spectral, spatial or temporal characteristics of a light-emitting device using a volume Bragg grating (VBG) element. A VBG element recorded in photorefractive materials, such as those recorded in inorganic photorefractive glasses (PRGs), has many properties that can improve one or more characteristics of light-emitting devices such as solid-state lasers, semiconductor laser diodes, gas and ion lasers, and the like. The VBG element receives input light generated by a light-emitting device, conditions one or more characteristics of the input light, and causes the light-emitting device to generate light having the one or more characteristics of the conditioned light. The VBG element may be placed either outside the laser cavity of the light-emitting device or inside the laser cavity of the light-emitting device. A similar approach is also disclosed in an article entitled "Wavelength stabilization and spectrum narrowing of high-power multimode laser diodes and arrays by use of volume Bragg gratings" to Volodin et al., published in Optics Letters, Vol.29, No.16, August 15, 2004.

US Patent No. 7,212,553 B2, issued to Starodoumov et al., entitled "Wavelength stabilized diode-laser array" is directed to a method and apparatus for stabilizing the lasing wavelength of a plurality of multimode diode-lasers. In one embodiment, the method includes providing a wavelength selective reflecting device having a peak reflection wavelength within the emitting bandwidth of the diode-lasers. Light emitted by the plurality of diode-lasers is coupled into a single multimode optical fiber. Light from the multimode optical fiber is directed to the wavelength selective reflecting device, with a portion of the light having the peak reflection wavelength being reflected from the wavelength selective reflecting device back along the multimode optical fiber and back into the plurality of diode-lasers. The reflected light causes the wavelength of light emitted from each one of the plurality of diode-lasers to lock onto the peak reflection wavelength. The wavelength selective reflective device may be a fiber Bragg grating (FBG) or a volume Bragg grating (VBG). Light from the multimode optical fiber may be collimated prior to reflecting the light from the wavelength selective reflecting device.

US Patent No. 7,212,554 B2, issued to Zucker et al., entitled "Wavelength stabilized laser" is directed to a high power light source including a plurality of laser diodes, a plurality of multimode waveguides, an optical combiner and an at least partially reflective element. The multimode waveguides each have an end optically coupled to one of the plurality of laser diodes so as to collect beams of light emitted from the plurality of laser diodes and guide the beams of light propagating in a forward direction to a first collection location and for guiding light traversing the multimode waveguides in an opposite direction to the plurality of laser diodes. The optical combiner receives the beams of light propagating in the forward direction from the first collection location and combines the beams of light into a single forward propagating beam of light. The optical combiner also separates a received beam of light traversing in an opposite direction into separate beams of light at the collection location and provides them as optical feedback to the plurality of laser diodes. The partially reflective element receives the single forward propagating beam of light and is designed to transmit more than 60% of the single forward propagating beam of light therethrough, and to reflect between 3-40% of the single forward propagating beam back to the laser diodes as feedback to stabilize them. The partially reflecting element may be a filter having a bandwidth of 1-7 nanometers (nm) with a reflectivity of 5-40%, having a center wavelength of at least one of 792 nm, 808 nm, 915 nm, 938 nm and 976 nm.

US Patent No. 7,542,489 B2, issued to Luo et al., entitled "Injection seeding employing continuous wavelength sweeping for master-slave resonance" is directed to a method for effective injection seeding. The method is based on a continuous wavelength sweeping in order to match injected seeds with one or more longitudinal mode(s) of a slave oscillator in every pump pulse. The method achieves this through rapidly varying the laser drive current resulting from RF modulation. Depending on the modulation parameters, the seed may be operated in a quasi-CW mode or a pulsed mode, with a narrow or broad bandwidth, for injection seeding of a single longitudinal mode or a multimode. From pulse to pulse, the master-slave resonance may occur at different wavelengths depending upon cavity length fluctuations, therefore cavity length control using complicated feedback devices and phase locking schemes are not required.

US Patent No. 7,633,979 B2, issued to Luo et al., entitled "Method and apparatus for producing UV laser from all-solid-state system" is directed to an all-solid-state UV laser capable of producing laser pulses having a short pulse width (<1 ns), a variable pulse shape and a high repetition rate (>100 kHz). The apparatus includes a seed laser, producing wavelength-swept optical seeds, a slave laser and incoherent and quasi-monochromatic light sources, such as LED arrays, as a pump source, for optically activating a solid-state gain media of the slave laser. The slave laser gain medium has a broad emission spectrum or several discrete emission wavelengths. Pulsed operation of the solid-state laser is achieved by Q-switching or gain switching. The apparatus also includes a recycling mechanism, such as a diffusion pump chamber, for providing diffuse reflection of the pump light. The solid-state laser output wavelength is stabilized by injection seeding in such a way that master-slave resonance is realized by continuous sweeping of the seed wavelength which thus eliminates the need for active cavity length control and phase locking. The wavelength of the solid-state laser output is converted to UV via one or more nonlinear optical processes. The output wavelength of the solid-state UV laser can be adjusted by selecting a seed that emits laser beam at a wavelength that is, or nearly is, an integer multiple of the desired UV output wavelength.

### SUMMARY OF THE DISCLOSED TECHNIQUE

It is an object of the disclosed technique to provide a novel system for wavelength stabilization and linewidth narrowing in single mode and multimode laser diodes. In accordance with an embodiment of the disclosed technique, there is thus provided a system for wavelength stabilization in a multimode (MM) laser diode (LD), including at least one MM LD, a respective at least one MM 2X2 beam splitter for each MM LD, an isolator and at least one LD. The LD is coupled with the isolator and each respective MM 2x2 beam splitter includes four ports. The MM LD is for generating high power MM laser light, the isolator is for enabling laser light to pass through in only one direction and the LD is for generating low power laser light. Each respective MM 2X2 beam splitter is for splitting the generated high power MM laser light and the generated low power laser light and has a highly asymmetric splitting ratio. A first port and a third port of each respective MM 2X2 beam splitter each outputs a significantly high percent of the generated high power MM laser light and the generated low power laser light. A second port and a fourth port of each respective MM 2X2 beam splitter each outputs a significantly low percent of the generated high power MM laser light and the generated low power laser light. Each MM LD is respectively coupled with the fourth port of each respective MM 2X2 beam splitter. A wavelength of the generated high power MM laser light locks onto a wavelength of the generated low power laser light, thereby wavelength stabilizing the MM LD. The first port of each respective MM 2X2 beam splitter outputs the generated high power MM laser light as wavelength stabilized high power MM laser light.

In accordance with another embodiment of the disclosed technique, there is thus provided a system for wavelength stabilization in a multimode (MM) laser diode (LD), including at least one MM LD, a respective at least one MM 2X2 beam splitter for each MM LD and a wavelength selective mirror. The MM LD is for generating MM laser light, the MM 2X2 beam splitter is for splitting the generated MM laser light and the wavelength selective mirror is for selectively reflecting laser light at a specific narrow bandwidth. Each respective MM 2X2 beam splitter includes four ports and has a highly asymmetric splitting ratio. A first port and a third port of each respective MM 2X2 beam splitter each outputs a significantly high percent of the generated MM laser light. A second port and a fourth port of each respective MM 2X2 beam splitter each outputs a significantly low percent of the generated MM laser light. The wavelength selective mirror is coupled with the second port of a first one of the respective MM 2X2 beam splitter and reflects the generated MM laser light in the specific narrow bandwidth. Each MM LD is respectively coupled with the fourth port of each respective MM 2X2 beam splitter. A wavelength of the generated MM laser light of each MM LD locks onto a wavelength of the reflected MM laser light, thereby wavelength stabilizing each MM LD. The first port of each respective MM 2X2 beam splitter outputs the generated MM laser light as wavelength stabilized MM laser light.

In accordance with a further embodiment of the disclosed technique, there is thus provided a system for wavelength stabilization in a single mode (SM) laser diode (LD), including a first SM LD, a SM 2X2 beam splitter, a first isolator and a second SM LD. The second SM LD is coupled with the first isolator. The first SM LD is for generating high power SM laser light, the first isolator is for enabling laser light to pass through in only one direction and the second SM LD is for generating low power SM laser light. The SM 2X2 beam splitter is for splitting the generated low power and high power SM laser light, has a highly asymmetric splitting ratio and includes four ports. A first port and a third port of the SM 2X2 beam splitter each outputs a significantly high percent of the generated low power and high power SM laser light. A second port and a fourth port of the SM 2X2 beam splitter each outputs a significantly low percent of the generated low power and high power SM laser light. The first isolator is coupled with the second port and the first SM LD is coupled with the fourth port. A wavelength of the generated high power SM laser light locks onto a wavelength of the generated low power SM laser light, thereby wavelength stabilizing the first SM LD. The first port outputs the generated high power SM laser light as wavelength stabilized high power SM laser light.

### BRIEF DESCRIPTION OF THE DRAWINGS

The disclosed technique will be understood and appreciated more fully from the following detailed description taken in conjunction with the drawings in which:
Figure 1A is a schematic illustration of a prior art wavelength stabilization system;
Figure 1B is a schematic illustration of a 2X2 beam splitter, constructed and operative in accordance with an embodiment of the disclosed technique;
Figure 2 is a schematic illustration of a system for wavelength stabilization in a single mode laser diode, constructed and operative in accordance with another embodiment of the disclosed technique;
Figure 3A is a schematic illustration of a system for wavelength stabilization in a multimode laser diode using a single mode laser diode, constructed and operative in accordance with a further embodiment of the disclosed technique;
Figure 3B is a schematic illustration of a system for wavelength stabilization in a plurality of multimode laser diodes using a single mode laser diode, constructed and operative in accordance with another embodiment of the disclosed technique;
Figure 3C is another schematic illustration of a system for wavelength stabilization in a plurality of multimode laser diodes using a single mode laser diode, constructed and operative in accordance with a further embodiment of the disclosed technique;
Figure 3D is another schematic illustration of a system for wavelength stabilization in a multimode laser diode using a single mode to multimode splice, constructed and operative in accordance with another embodiment of the disclosed technique;
Figure 4A is a further schematic illustration of a system for wavelength stabilization in a multimode laser diode using a fiber Bragg grating, constructed and operative in accordance with a further embodiment of the disclosed technique;
Figure 4B is a further schematic illustration of a system for wavelength stabilization in a plurality of multimode laser diodes using a fiber Bragg grating, constructed and operative in accordance with another embodiment of the disclosed technique;
Figure 5A is a schematic illustration of a system for wavelength stabilization in a multimode laser diode using a coated optical fiber mirror, constructed and operative in accordance with a further embodiment of the disclosed technique;
Figure 5B is a schematic illustration of a system for wavelength stabilization in a plurality of multimode laser diodes using a coated optical fiber mirror, constructed and operative in accordance with another embodiment of the disclosed technique;
Figure 6A is another schematic illustration of a system for wavelength stabilization in a multimode laser diode using an optical fiber mirror and a band pass filter, constructed and operative in accordance with a further embodiment of the disclosed technique; and
Figure 6B is another schematic illustration of a system for wavelength stabilization in a plurality of multimode laser diodes using an optical fiber mirror and a band pass filter, constructed and operative in accordance with another embodiment of the disclosed technique.

### DETAILED DESCRIPTION OF THE EMBODIMENTS

The disclosed technique overcomes the disadvantages of the prior art by providing a novel laser diode architecture for wavelength stabilizing single mode and multimode laser diodes operating in a continuous wave (CW) mode or pulsed mode of operation. According to one embodiment of the disclosed technique, a seed laser diode is used to stabilize the wavelength of a slave laser diode which outputs a beam of laser light. According to another embodiment of the disclosed technique, a high reflection fiber Bragg grating is used to stabilize the wavelength of a multimode laser diode. According to a further embodiment of the disclosed technique, an optical fiber mirror is used to stabilize the wavelength of a multimode laser diode. It is noted that throughout the description, the terms "light," "laser light," "beam of light," "laser beam" and "beam of laser light" are used interchangeably to refer to the laser light generated by a laser diode. In addition, the terms "fiber" and "optical fiber" are also used interchangeably.

Reference is now made to Figure 1B, which is a schematic illustration of a 2X2 beam splitter, generally referenced 30, constructed and operative in accordance with an embodiment of the disclosed technique. Generally speaking, a beam splitter is an element that splits or combines light from one or more input ports to one or more output ports. 2X2 beam splitter 30 includes four ports 32A, 32B, 32C and 32D, a splitting element 34 and four optical fibers 36A, 36B, 36C and 36D. Each one of ports 32A, 32B, 32C and 32D is coupled with splitting element 34 via a respective one of optical fibers 36A, 36B, 36C and 36D. Each one of ports 32A, 32B, 32C and 32D can function as an input port or an output port depending on how the respective port is coupled with any surrounding elements. This is depicted by arrow heads on each one of optical fibers 36A, 36B, 36C and 36D. Splitting element 34 splits or combines light signals received from the different ports in 2X2 beam splitter 30. A 2X2 beam splitter is characterized by a splitting ratio of X:Y, where X+Y=1. In the case of a light signal being inputted into port 32A, the light signal will exit ports 32C and 32D, which are on opposite sides of splitting element 34, respectively carrying X times the power of the original light signal in one port and Y times the power of the original light signal in the other port. For example, if 2X2 beam splitter 30 is characterized by a splitting ratio of 5%:95% then if a signal with a power of 100 milliwatts is inputted via port 32A, the output power of the signal at port 32C will be 95 milliwatts and the output power of the signal at port 32D will be 5 milliwatts. 2X2 beam splitter 30 thus splits the optical power in one optical fiber into two optical fibers at a given ratio. It is noted that in the example given above, no signal will be emitted from port 32B. The output signals of 2X2 beam splitter 30 carry the same spectral and temporal properties as the input signal, the only difference being in the intensity, or power, of the outputted signals. As mentioned above, either one of ports 32A and 32B or 32C and 32D can be input ports or output ports. It should be noted that 2X2 beam splitter 30 as described in Figure 1B is an ideal 2X2 beam splitter. Actual 2X2 beam splitters usually suffer a small amount of power loss, such that the sum of the power of the signal exiting the 2X2 beam splitter will not be exactly equal to the power of the signal entered into the 2X2 beam splitter. Also actual 2X2 beam splitters may slightly distort the spectral and temporal properties of an input signal. Using the example above, the sum of the power of the signals coming out of ports 32C and 32D will not exactly equal the power of the signal entered into port 32A, as a small portion of the entered signal will be lost in 2X2 beam splitter 30. In addition, some of the entered signal might be reflected back from splitting element 34 into ports 32A and 32B. Furthermore, splitting element 34 and optical fibers 36A-36D may distort the spectral and temporal properties of the inputted signal.

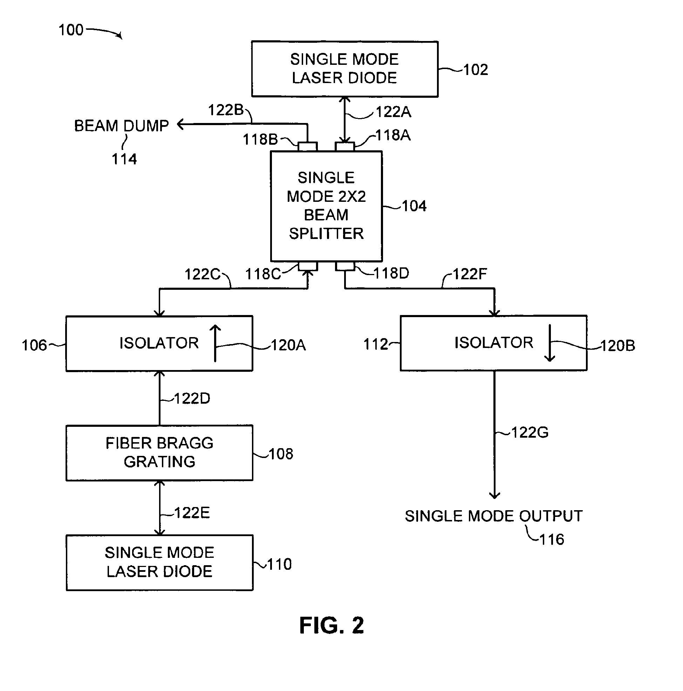

2X2 beam splitter 30 is a linear device in the sense that if a light signal is fed into more than one input port, the light signal exiting each output port is the sum of the light signals that would exit each output port if each of the input ports were alone fed a light signal. For example, assume that 2X2 beam splitter 30 has a splitting ratio of 95%:5%. If simultaneously a first light signal S1 is entered into port 32A and a second light signal S2 is entered into port 32B, then the output of port 32C will include 95% of the power in first light signal S1 and 5% of the power in second light signal S2, and the output of port 32D will include 5% of the power in first light signal S1 and 95% of the power in second light signal S2. In this manner 2X2 beam splitter 30 can also function as a beam combiner. Regarding the splitting ratio, as defined above, when X equals Y, the splitting ratio is said to be symmetric. According to the disclosed technique, as shown below in Figures 2-6B, highly asymmetric 2X2 beam splitters are used, with splitting ratios on the order of a few percents, such as, for example 5%:95% or 1%:99%. The highly asymmetric splitting ratios used in the disclosed technique can range from 0.1%:99.9% up until 25%:75% and is a matter of design choice of the worker skilled in the art. This is in the case of a single mode 2X2 beam splitter as well as in the case of a multimode 2X2 beam splitter.

Reference is now made to Figure 2, which is a schematic illustration of a system for wavelength stabilization in a single mode laser diode, generally referenced 100, constructed and operative in accordance with another embodiment of the disclosed technique. System 100 includes a first single mode laser diode 102, a single mode 2X2 beam splitter 104, a first isolator 106, an FBG 108, a second single mode laser diode 110, a second isolator 112, a beam dump 114 and optical fibers 122A, 122B, 122C, 122D, 122E, 122F and 122G. Single mode 2X2 beam splitter 104 includes four ports, labeled 118A, 118B, 118C and 118D. Single mode 2X2 beam splitter 104 is substantially similar in construction and design to 2X2 beam splitter 30 (Figure 1 B). First single mode laser diode 102 is coupled with port 118A via optical fiber 122A. Port 118B is coupled with beam dump 114 via optical fiber 122B. Beam dump 114 substantially absorbs beams of light and can be thought of as a sort of garbage bin for unwanted laser light. Port 118C is coupled with first isolator 106 via optical fiber 122C. FBG 108 is coupled with first isolator 106 via optical fiber 122D, and with second single mode laser diode 110 via optical fiber 122E. Port 118D is coupled with second isolator 112 via optical fiber 122F. Second isolator is coupled with optical fiber 122G from which a laser beam is outputted. Optical fiber 122G can be coupled with other elements (not shown) for further processing a laser beam before it is outputted. It is noted that FBG 108, second isolator 112 and beam dump 114 are optional components in system 100. It is also noted that optical fibers 122A-122G are single mode optical fibers. First isolator 106 and second isolator 112 can be embodied as optical isolators.

In general, optical isolators are devices which enable laser light to pass through in only one direction. In Figure 2, each one of first isolator 106 and second isolator 112 enables laser light to pass through in only one direction, as depicted respectively by arrows 120A and 120B. The general flow of laser light in system 100 is depicted by the arrow heads on optical fibers 122A-122G. As can be seen, laser light enters single mode 2X2 beam splitter 104 via ports 118A and 118C. When laser light enters port 118A, it is outputted via ports 118C and 118D, and when laser light enters port 118C, it is outputted via ports 118A and 118B, as shown by the arrow heads on optical fibers 122A, 122B, 122C and 122F. The splitting ratio of single mode 2X2 beam splitter 104 is such that one output port outputs a majority of the energy of the input laser beam, whereas the other output port outputs a small amount of energy of the input laser beam. As mentioned above, the splitting ratio of single mode 2X2 beam splitter 104 can be, for example, 95%:5%, 99%:1% or anywhere ranging from 75%:25% to 99.9%:0.1%. To simplify the explanation of the disclosed technique, as an example, a splitting ratio of 95%:5% will be assumed in the 2X2 beam splitters (single mode and multimode) shown in the various embodiments of the disclosed technique, it being understood that any other splitting ratio can be used provided that one output port outputs most of the laser light and the other output port outputs a small amount of the laser light. In general, laser light arriving at port 118A is outputted via ports 118C and 118D such that 95% of the laser light is provided to second isolator 112 and 5% of the laser light is provided to first isolator 106. Laser light arriving at port 118C is outputted via ports 118A and 118B such that 95% of the laser light is provided to beam dump 114 and 5% of the laser light is provided to first single mode laser diode 102.

In system 100, first single mode (SM) laser diode 102 and second single mode (SM) laser diode 110 are both laser diodes that generate single mode laser light. As such, single mode 2X2 beam splitter 104 is a beam splitter designed for splitting single mode laser light. In the setup shown, first single mode laser diode 102 can be referred to as a SM slave laser diode, whereas second single mode laser diode 110 can be referred to as a SM seed laser diode or a SM master laser diode. Such terminology is used, since the laser light generated by second single mode laser diode 110 is provided to first single mode laser diode 102. In general, second single mode laser diode 110 can be any type of low power laser diode having a narrow and specific bandwidth, whereas first single mode laser diode 102 can be any type of high power laser diode having a wide bandwidth. As described in further detail below, the light generated by SM master laser diode 110, which has a narrow bandwidth, is used to wavelength stabilize the light generated by SM slave laser diode 102. Using a laser diode to wavelength stabilize SM slave laser diode 102 overcomes the disadvantages of the prior art, since SM slave laser diode 102 can be wavelength stabilized while operating in CW mode as well in a pulsed mode of operation without having to embed an FBG on the SM slave laser diode and without having to place the FBG substantially close to the SM slave laser diode and provide it with a cooling element. In general, SM master laser diode 110 is always operated in a CW mode, while SM slave laser diode 102 can be operated in a CW mode or in a pulsed mode of operation. In general, master laser diodes or seed laser diodes used in the disclosed technique are always operated only in CW mode since if they were operated in a pulsed mode they would exhibit the same limitations of a slave laser diode, namely being limited to locking wavelengths of only substantially long pulses. Since SM slave laser diode 102 is constantly being provided with laser light having a stable wavelength from SM master laser diode 110, SM slave laser diode 102 can lock onto the wavelength of SM master laser diode 110 whether SM slave laser diode 102 operates in a CW mode or a pulsed mode of operation.

SM slave laser diode 102 is wavelength stabilized as follows. SM master laser diode 110 provides laser light having a narrow bandwidth to FBG 108 via optical fiber 122E. FBG 108 provides most of the laser light to first isolator 106 via optical fiber 122D, while reflecting a small portion of the laser light back to SM master laser diode 110. This is shown by the double headed arrow on optical fiber 122E and single headed arrow on optical fiber 122D. As mentioned above, FBG 108 is an optional component. For example, if SM master laser diode 110 has an internal Bragg grating (not shown), is thermally controlled or both, then FBG 108 can be removed form system 100. If FBG 108 is used, then it can be used to wavelength stabilize SM master laser diode 110. In such a case, SM master laser diode 110 can be a SM laser diode having a wide bandwidth. If FBG 108 is not used in system 100, then SM master laser diode 110 should be a SM laser diode having a stable wavelength. In such a case, the laser light generated by SM master laser diode 110 is provided directly to first isolator 106 via an optical fiber (not shown). In either case, the temperature of SM master laser diode 110 can be modified such that a specified wavelength of light is generated by SM master laser diode 110. First isolator 106 receives the laser light generated by SM master laser diode 110 and provides the laser light to port 118C of SM 2X2 beam splitter 104 via optical fiber 122C. SM 2X2 beam splitter 104 splits the received laser beam such that, as per the example mentioned above, 95% of the laser beam is provided to port 118B and 5% of the laser beam is provided to port 118A. The 95% of the laser beam provided to port 118B is provided via optical fiber 122B to beam dump 114. As shown on optical fiber 122B as a single headed arrow, beam dump 114 does not reflect any laser light back to SM 2X2 beam splitter 104. The 5% of the laser beam provided to port 118A is provided, via optical fiber 122A, to SM slave laser diode 102.

SM slave laser diode 102 generates laser light having a wide bandwidth. As the 5% of the laser light generated by SM master laser diode 110 is provided to SM slave laser diode 102, the wavelength of light generated by SM slave laser diode 102 locks onto the wavelength of light generated by SM master laser diode 110. The light generated by SM master laser diode 110 is seed light provided to SM slave laser diode 102. SM slave laser diode 102 provides its wavelength stabilized laser light to port 118A via optical fiber 122A, as shown by the double headed arrow on optical fiber 122A. SM 2X2 beam splitter 104 receives the laser light from SM slave laser diode 102 and splits the received light, as per the example mentioned above, such that 95% of the laser light is provided to second isolator 112 via port 118D and optical fiber 122F and 5% of the laser light is provided to first isolator 106 via port 118C and optical fiber 122C. This flow of laser light is shown by the arrow heads on optical fibers 122C and 122F. The laser light provided to first isolator 106 is either absorbed by isolator 106 or reflected back to SM 2X2 beam splitter 104, since first isolator 106 only enables laser light to flow in the direction of arrow 120A. The laser light provided to second isolator 112 is provided to optical fiber 122G and can then be outputted. As shown, since SM slave laser diode 102 is a single mode laser diode, thus an output 116 of optical fiber 122G is single mode laser light. As mentioned above, second isolator 112 is an optional component, and is generally used to prevent any laser light returning to system 100. Since second isolator 112 only enables light to flow in the direction of arrow 120B, any laser light returning along optical fiber 122G to second isolator 112 will not be provided to SM 2X2 beam splitter 104. As an example, SM slave laser diode 102 may be provided with laser light within the range of 1060-1080 nm, 1540-1560 nm or 1900-2100 nm. The laser light provided by SM master laser diode 110 to SM slave laser diode 102 may have a narrower wavelength within the specified ranges above in order to wavelength stabilize SM slave laser diode 102.

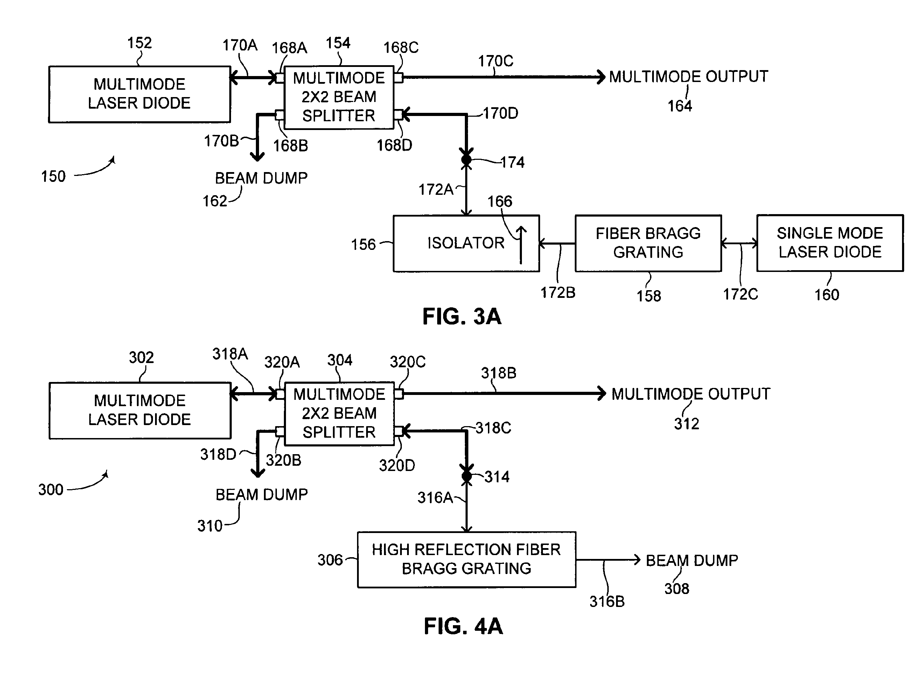

Reference is now made to Figure 3A, which is a schematic illustration of a system for wavelength stabilization in a multimode laser diode using a single mode laser diode, generally referenced 150, constructed and operative in accordance with a further embodiment of the disclosed technique. System 150 includes a multimode laser diode 152, a multimode 2X2 beam splitter 154, an isolator 156, an FBG 158, a single mode laser diode 160, a beam dump 162, multimode optical fibers 170A, 170B, 170C and 170D, single mode optical fibers 172A, 172B and 172C and a single mode to multimode optical fiber splice 174. Multimode (MM) 2X2 beam splitter 154 includes four ports, labeled 168A, 168B, 168C and 168D. MM 2X2 beam splitter 154 is substantially similar in construction and design to SM 2X2 beam splitter 104 (Figure 2), except that MM 2X2 beam splitter 154 is designed to split multimode laser beams. MM laser diode 152 is coupled with port 168A via MM optical fiber 170A. Port 168B is coupled with beam dump 162 via MM optical fiber 170B. Beam dump 162 is substantially similar to beam dump 114 (Figure 2). Port 168C is coupled with MM optical fiber 170C, which provides a multimode output 164 of MM laser light. FBG 158 is coupled with isolator 156 via SM optical fiber 172B, and with SM laser diode 160 via SM optical fiber 172C. Port 168D is coupled with MM optical fiber 170D. Isolator 156 is coupled with SM optical fiber 172A. SM optical fiber 172A is coupled with MM optical fiber 170D via single mode to multimode optical fiber splice 174. It is noted that MM optical fiber 170C can be coupled with other elements (not shown) for further processing a laser beam before it is outputted. It is noted that FBG 158 and beam dump 162 are an optional components in system 150.

Isolator 156 enables laser light to pass through only in the direction depicted by an arrow 166, from FBG 158 to SM optical fiber 172A. The general flow of laser light in system 150 is depicted by the arrow heads on MM optical fibers 170A-170D and SM optical fibers 172A-172C. As mentioned above, the splitting ratio of MM 2X2 beam splitter 154 is such that one output port outputs a majority of the energy of the input laser beam, whereas the other output port outputs a small amount of energy of the input laser beam. In system 150, SM laser diode 160 can be referred to as a SM master laser diode or a SM seed laser diode, whereas MM laser diode 152 can be referred to as a MM slave laser diode. In general, SM laser diode 160 can be any type of low power laser diode having a narrow and specific bandwidth, whereas MM laser diode 152 can be any type of high power laser diode having a wide bandwidth. As described in further detail below, the light generated by SM master laser diode 160, which has a narrow bandwidth, is used to wavelength stabilize the light generated by MM slave laser diode 152. SM master laser diode 160 always operates in a CW mode. MM slave laser diode 152 can operate in a CW mode or a pulsed mode of operation. In general, MM slave laser diode 152 is constantly being provided with laser light having a stable wavelength from SM master laser diode 160, thereby enabling MM slave laser diode 152 to lock onto the wavelength of SM master laser diode 160 whether MM slave laser diode 152 operates in a CW mode or a pulsed mode of operation.

MM slave laser diode 152 is wavelength stabilized as follows. SM master laser diode 160 provides SM laser light having a narrow bandwidth to FBG 158 via SM optical fiber 172C. FBG 158 provides most of the SM laser light to isolator 156 via SM optical fiber 172B, while reflecting a small portion of the SM laser light back to SM master laser diode 160. This is shown by the double headed arrow on SM optical fiber 172C and single headed arrow on SM optical fiber 172B. As mentioned above, FBG 158 is an optional component. If FBG 158 is used, then it can be used to wavelength stabilize SM master laser diode 160. In such a case, SM master laser diode 160 can be a SM laser diode having a wide bandwidth. If FBG 158 is not used in system 150, then SM master laser diode 160 should be a SM laser diode having a stable wavelength. In this embodiment, SM master laser diode 160 may include an internal Bragg grating (not shown), may be thermally controlled, or may include both. In such a case, the SM laser light generated by SM master laser diode 160 is provided directly to isolator 156 via an optical fiber (not shown). In either case, the temperature of SM master laser diode 160 can be modified such that a specified wavelength of light is generated by SM master laser diode 160. Isolator 156 receives the SM laser light generated by SM master laser diode 160 and provides the SM laser light to SM optical fiber 172A. SM optical fiber 172A provides the SM laser light to MM optical fiber 170D via single mode to multimode optical fiber splice 174. When the SM laser light coming from isolator 156 is provided to MM optical fiber 170D, due to the increased size of the inner diameter (not shown) of MM optical fibers, the SM laser light may become MM laser light. MM optical fiber 170D provides the laser light, either SM laser light or MM laser light, to port 168D of MM 2X2 beam splitter 154. MM 2X2 beam splitter 154 splits the received laser beam such that, as per the example mentioned above, 95% of the laser beam is provided to port 168B and 5% of the laser beam is provided to port 168A. The 95% of the laser beam provided to port 168B is provided via MM optical fiber 170B to beam dump 162. As shown on MM optical fiber 170B as a single headed arrow, beam dump 162 does not reflect any laser light back to MM 2X2 beam splitter 154. The 5% of the laser beam provided to port 168A is provided, via MM optical fiber 170A, to MM slave laser diode 152.

MM slave laser diode 152 generates MM laser light having a wide bandwidth. As the 5% of the laser light generated by SM master laser diode 160 is provided to MM slave laser diode 152, the wavelength of MM light generated by MM slave laser diode 152 locks onto the wavelength of light generated by SM master laser diode 160. The light generated by SM master laser diode 160 is seed light provided to MM slave laser diode 152. It is noted that the MM laser light generated by MM slave laser diode 152 will lock onto the wavelength of the light provided from SM master laser diode 160, whether the laser light provided to MM optical fiber 170D from isolator 156 remains SM laser light or becomes MM laser light. MM slave laser diode 152 provides its wavelength stabilized MM laser light to port 168A via MM optical fiber 170A, as shown by the double headed arrow on MM optical fiber 170A. MM 2X2 beam splitter 154 receives the MM laser light from MM slave laser diode 152 and splits the received light, as per the example mentioned above, such that 95% of the MM laser light is provided as MM laser light to MM output 164 via port 168C and MM optical fiber 170C. 5% of the MM laser light is provided to isolator 156 via port 168D and MM optical fiber 170D. Single mode to multimode optical fiber splice 174 provides partial isolation of the MM laser light, as SM optical fiber 172A has a smaller inner diameter (not shown) than the inner diameter of MM optical fiber 170D, thereby preventing substantially most of the modes of the MM laser light in MM optical fiber 170D to be provided to SM optical fiber 172A. This flow of laser light is shown by the arrow heads on MM optical fiber 170D and SM optical fiber 172A. The remainder of the MM laser light which reaches isolator 156 is either absorbed by isolator 156 or reflected back to MM 2X2 beam splitter 154, since isolator 156 only enables laser light to flow in the direction of arrow 166. The laser light provided to MM optical fiber 170C is outputted. As shown, since MM slave laser diode 152 is a multimode laser diode, then an output 164 of MM optical fiber 170C is a multimode mode laser light.

It is noted that in another embodiment of the disclosed technique, SM laser diode 160 is replaced by a MM laser diode, and FBG 158 is replaced by a volume Bragg grating (VBG). In such an embodiment, SM optical fibers 172B and 172C are replaced with MM optical fibers and isolator 156 is coupled with port 168D directly using a MM optical fiber. In this embodiment, the VBG may be optional and the MM laser diode may be coupled directly with isolator 156 if the MM laser diode has a stable wavelength.

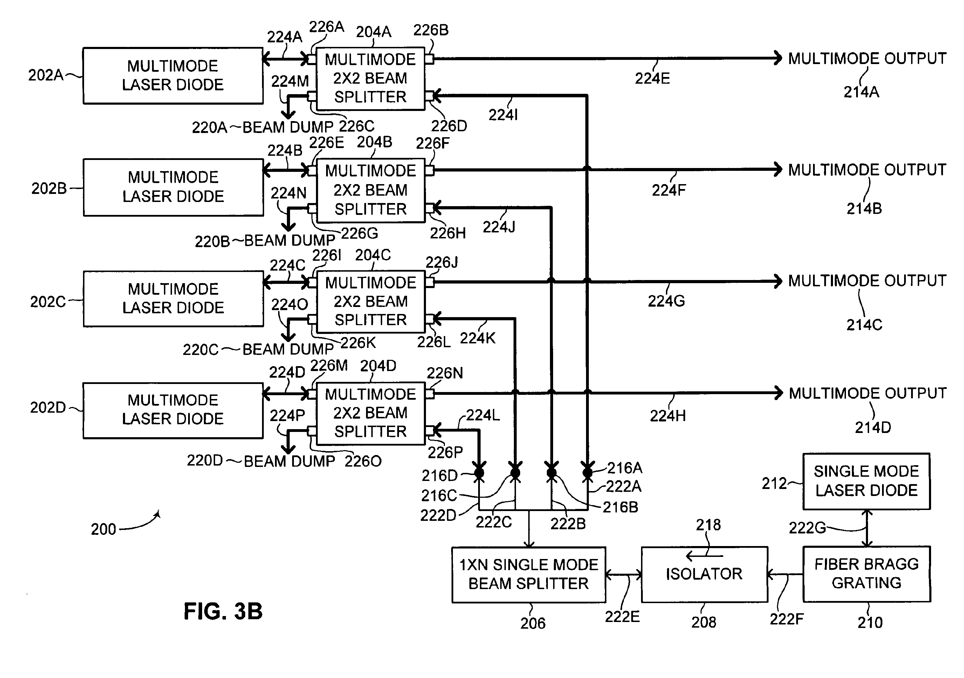

Reference is now made to Figure 3B, which is a schematic illustration of a system for wavelength stabilization in a plurality of multimode laser diodes using a single mode laser diode, generally referenced 200, constructed and operative in accordance with another embodiment of the disclosed technique. System 200 includes a plurality of multimode laser diodes 202A, 202B, 202C and 202D, a plurality of multimode 2X2 beam splitters 204A, 204B, 204C and 204D, a 1XN single mode beam splitter 206, an isolator 208, an FBG 210, a single mode laser diode 212, a plurality of beam dumps 220A, 220B, 220C and 220D, a plurality of multimode optical fibers 224A, 224B, 224C, 224D, 224E, 224F, 224G, 224H, 224I, 224J, 224K, 224L, 224M, 224N, 2240 and 224P, a plurality of single mode optical fibers 222A, 222B, 222C, 222D, 222E, 222F and 222G and a plurality of single mode to multimode optical fiber splices 216A, 216B, 216C and 216D. Each one of plurality of multimode (MM) 2X2 beam splitters 204A-204D includes four ports. MM 2X2 beam splitter 204A includes ports 226A, 226B, 226C and 226D. MM 2X2 beam splitter 204B includes ports 226E, 226F, 226G and 226H. MM 2X2 beam splitter 204C includes ports 226I, 226J, 226K and 226L. MM 2X2 beam splitter 204D includes ports 226M, 226N, 2260 and 226P. Each one of plurality of MM 2X2 beam splitters 204A-204D is substantially similar in construction and design to MM 2X2 beam splitter 154 (Figure 3A).

MM laser diode 202A is coupled with port 226A via MM optical fiber 224A. Port 226C is coupled with beam dump 220A via MM optical fiber 224M. Port 226B is coupled with MM optical fiber 224E, which provides a multimode output 214A of MM laser light. Port 226D is coupled with MM optical fiber 224I. MM laser diode 202B is coupled with port 226E via MM optical fiber 224B. Port 226G is coupled with beam dump 220B via MM optical fiber 224N. Port 226F is coupled with MM optical fiber 224F, which provides a multimode output 214B of MM laser light. Port 226H is coupled with MM optical fiber 224J. MM laser diode 202C is coupled with port 226I via MM optical fiber 224C. Port 226K is coupled with beam dump 220C via MM optical fiber 2240. Port 226J is coupled with MM optical fiber 224G, which provides a multimode output 214C of MM laser light. Port 226L is coupled with MM optical fiber 224K. MM laser diode 202D is coupled with port 226M via MM optical fiber 224D. Port 2260 is coupled with beam dump 220D via MM optical fiber 224P. Port 226N is coupled with MM optical fiber 224H, which provides a multimode output 214D of MM laser light. Port 226P is coupled with MM optical fiber 224L. FBG 210 is coupled with isolator 208 via SM optical fiber 222F, and with SM laser diode 212 via SM optical fiber 222G. Isolator 208 is coupled with 1XN SM beam splitter 206 via SM optical fiber 222E. 1XN SM beam splitter 206 is coupled with each one of plurality of SM to MM optical fiber splices 216A-216D via respective ones of SM optical fibers 222A-222D. SM to MM optical fiber splice 216A couples SM optical fiber 222A to MM optical fiber 224I. SM to MM optical fiber splice 216B couples SM optical fiber 222B to MM optical fiber 224J. SM to MM optical fiber splice 216C couples SM optical fiber 222C to MM optical fiber 224K. SM to MM optical fiber splice 216D couples SM optical fiber 222D to MM optical fiber 224L. It is noted that each one of MM optical fibers 224E, 224F, 224G and 224H can be coupled with other elements (not shown) for further processing a laser beam before it is outputted. It is also noted that each one of plurality of beam dumps 220A-220D is substantially similar to beam dump 162 (Figure 3A). It is noted that plurality of beam dumps 220A, 220B, 220C and 220D are optional components in system 200. It is also noted that FBG 210 is an optional component in system 200, for example, if SM laser diode 212 is stabilized by an internal Bragg grating (not shown), by being thermally controlled, or by both. In such a case, SM laser diode 212 is coupled directly with isolator 208. In another embodiment, both FBG 210 and isolator 208 are optional components in system 200. In such a case, SM laser diode 212 is coupled directly with 1XN SM beam splitter 206. In a further embodiment, SM laser diode 212 is replaced by a MM laser diode, and FBG 210 can be replaced with a volume Bragg grating (VBG). In this embodiment, 1XN SM beam splitter 206 is replaced with a 1XN MM beam splitter, which is coupled with ports 226D, 226H, 226L and 226P directly using MM optical fibers. In addition, SM optical fibers 222E-222G would be replaced with MM optical fibers. The VBG in this embodiment may be optional and the MM laser diode may be coupled directly with isolator 208 if the MM laser diode has a stable wavelength.

Isolator 208 enables laser light to pass through only in the direction depicted by an arrow 218, from FBG 210 to 1XN SM beam splitter 206. The general flow of laser light in system 200 is depicted by the arrow heads on plurality of MM optical fibers 224A-224P and plurality of SM optical fibers 222A-222G. As mentioned above, the splitting ratio of each of plurality of MM 2X2 beam splitters 204A-204D is such that one output port outputs a majority of the energy of the input laser beam, whereas the other output port outputs a small amount of energy of the input laser beam. In system 200, SM laser diode 212 can be referred to as a SM master laser diode or a SM seed laser diode, whereas each one of plurality of MM laser diodes 202A-202D can be referred to as a MM slave laser diode. In general, SM laser diode 212 can be any type of low power laser diode having a narrow and specific bandwidth, whereas each one of plurality of MM laser diodes 202A-202D can be any type of high power laser diode having a wide bandwidth. As described in further detail below, the light generated by SM master laser diode 212, which has a narrow bandwidth, is used to wavelength stabilize the light generated by each one of plurality of MM slave laser diodes 202A-202D. SM master laser diode 212 always operates in a CW mode. Each one of plurality of MM slave laser diodes 202A-202D can operate in a CW mode or a pulsed mode of operation. In general, each one of plurality of MM slave laser diodes 202A-202D is constantly being provided with laser light having a stable wavelength from SM master laser diode 212, thereby enabling each one of plurality of MM slave laser diodes 202A-202D to lock onto the wavelength of SM master laser diode 212 whether each one of plurality of MM slave laser diodes 202A-202D operates in a CW mode or a pulsed mode of operation.

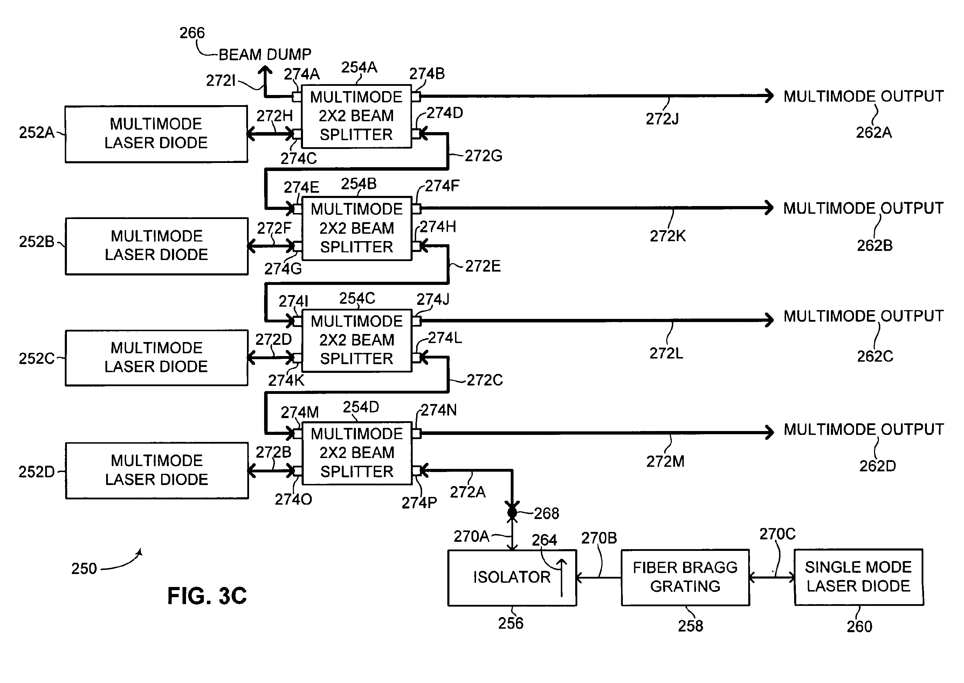

Using system 200, a plurality of MM slave laser diodes can be wavelength stabilized using a single SM master laser diode. It is noted that even though only four MM slave laser diodes are shown and described in Figure 3B, the laser setup in Figure 3B can be easily modified by a worker skilled in the art to accommodate a plurality of MM slave laser diodes being wavelength stabilized by a single SM master laser diode. As shown below, the same goes for the laser systems shown in Figures 3C, 4B, 5B and 6B, where even though only four MM slave laser diodes are shown in those figures, the given laser setup in each figure can be easily modified by a worker skilled in the art to accommodate a plurality of MM slave laser diodes being wavelength stabilized by the disclosed technique in each of those figures.

Plurality of MM slave laser diodes 202A-202D are wavelength stabilized as follows. SM master laser diode 212 provides SM laser light having a narrow bandwidth to FBG 210 via SM optical fiber 222G. FBG 210 provides most of the SM laser light to isolator 208 via SM optical fiber 222F, while reflecting a small portion of the SM laser light back to SM master laser diode 212. This is shown by the double headed arrow on SM optical fiber 222G and single headed arrow on SM optical fiber 222F. FBG 210 is used to wavelength stabilize SM master laser diode 212. As such, SM master laser diode 212 can be a SM laser diode having a wide bandwidth, or a SM laser diode having a stable wavelength. In addition, the temperature of SM master laser diode 212 can be modified such that a specified wavelength of light is generated by SM master laser diode 212. As mentioned above, SM master laser diode 212 may also be a laser diode having a stable wavelength and thus FBG 210 may be optional in such a set up. Isolator 208 receives the SM laser light generated by SM master laser diode 212 and provides the SM laser light to 1XN SM beam splitter 206. 1XN SM beam splitter splits the SM laser light into four separate beams of laser light, providing a first beam of SM laser light to SM optical fiber 222A, a second beam of SM laser light to SM optical fiber 222B, a third beam of SM laser light to SM optical fiber 222C and a fourth beam of SM laser light to SM optical fiber 222D. SM optical fiber 222A provides the SM laser light to MM optical fiber 224I via single mode to multimode optical fiber splice 216A. SM optical fiber 222B provides the SM laser light to MM optical fiber 224J via single mode to multimode optical fiber splice 216B. SM optical fiber 222C provides the SM laser light to MM optical fiber 224K via single mode to multimode optical fiber splice 216C. SM optical fiber 222D provides the SM laser light to MM optical fiber 224L via single mode to multimode optical fiber splice 216D. When the SM laser light coming from 1XN SM beam splitter 206 is provided to each of MM optical fiber 224I, 224J, 224K and 224L, due to the increased size of the inner diameter (not shown) of MM optical fibers, the SM laser light may become MM laser light. MM optical fiber 224I provides the laser light, either SM laser light or MM laser light, to port 226D of MM 2X2 beam splitter 204A. MM optical fiber 224J provides the laser light, either SM laser light or MM laser light, to port 226H of MM 2X2 beam splitter 204B. MM optical fiber 224K provides the laser light, either SM laser light or MM laser light, to port 226L of MM 2X2 beam splitter 204C. MM optical fiber 224L provides the laser light, either SM laser light or MM laser light, to port 226P of MM 2X2 beam splitter 204D. MM 2X2 beam splitter 204A splits the received laser beam such that, as per the example mentioned above, 95% of the laser beam is provided to port 226C and 5% of the laser beam is provided to port 226A. MM 2X2 beam splitter 204B splits the received laser beam such that 95% of the laser beam is provided to port 226G and 5% of the laser beam is provided to port 226E. MM 2X2 beam splitter 204C splits the received laser beam such that 95% of the laser beam is provided to port 226K and 5% of the laser beam is provided to port 2261. MM 2X2 beam splitter 204D splits the received laser beam such that 95% of the laser beam is provided to port 2260 and 5% of the laser beam is provided to port 226M. The 95% of the laser beams respectively provided to ports 226C, 226G, 226K and 2260 are respectively provided via MM optical fibers 224M, 224N, 2240 and 224P to respective beam dumps 220A, 220B, 220C and 220D. As shown on MM optical fibers 224M, 224N, 2240 and 224P as single headed arrows, plurality of beam dumps 220A, 220B, 220C and 220D do not reflect any laser light respectively back to a given one of plurality of MM 2X2 beam splitters 204A-204D. The 5% of the laser beams respectively provided to ports 226A, 226E, 226I and 226M are respectively provided via MM optical fibers 224A, 224B, 224C and 224D, to respective MM slave laser diodes 202A, 202B, 202C and 202D.

Plurality of MM slave laser diodes 202A-202D generate MM laser light having a wide bandwidth. Each one of plurality of MM slave laser diodes 202A-202D is operated simultaneously. As the 5%/N (five percent divided by N, where N is the number of output ports of 1XN SM beam splitter 206. In the example shown in Figure 3B, N=4) of the laser light generated by SM master laser diode 212 is provided to each one of plurality of MM slave laser diodes 202A-202D, the wavelength of MM light generated by each one of plurality of MM slave laser diodes 202A-202D locks onto the wavelength of light generated by SM master laser diode 212, as the light generated by SM master laser diode 212 is seed light provided to each one of plurality of MM slave laser diodes 202A-202D. It is noted that the MM laser light generated by each one of plurality of MM slave laser diodes 202A-202D will lock onto the wavelength of the light provided from SM master laser diode 212, whether the laser light provided to MM optical fibers 224I, 224J, 224K and 224L from 1XN SM beam splitter 206 remains SM laser light or becomes MM laser light. Each one of plurality of MM slave laser diodes 202A-202D provides its wavelength stabilized MM laser light respectively to ports 226A, 226E, 226I and 226M via respective ones of MM optical fibers 224A, 224B, 224C and 224D, as shown by the double headed arrows on MM optical fibers 224A, 224B, 224C and 224D. MM 2X2 beam splitter 204A receives the MM laser light from MM slave laser diode 202A and splits the received light, as per the example mentioned above, such that 95% of the MM laser light is provided as MM laser light to MM output 214A via port 226B and MM optical fiber 224E. MM 2X2 beam splitter 204B receives the MM laser light from MM slave laser diode 202B and splits the received light such that 95% of the MM laser light is provided as MM laser light to MM output 214B via port 226F and MM optical fiber 224F. MM 2X2 beam splitter 204C receives the MM laser light from MM slave laser diode 202C and splits the received light such that 95% of the MM laser light is provided as MM laser light to MM output 214C via port 226J and MM optical fiber 224G. MM 2X2 beam splitter 204D receives the MM laser light from MM slave laser diode 202D and splits the received light such that 95% of the MM laser light is provided as MM laser light to MM output 214D via port 226N and MM optical fiber 224H. 5% of the MM laser light beams is respectively provided to 1XN SM beam splitter 206 via ports 226D, 226H, 226L and 226P and MM optical fibers 224I, 224J, 224K and 224L. Plurality of SM to MM optical fiber splices 216A-216D provide partial isolation of the MM laser light, as SM optical fibers 222A-22D have a smaller inner diameter (not shown) than the inner diameter of MM optical fibers 224I, 224J, 224K and 224L, thereby preventing substantially most of the modes of the MM laser light in MM optical fibers 224I, 224J, 224K and 224L to be provided respectively to SM optical fibers 222A-22D. This flow of laser light is shown by the arrow heads on MM optical fibers 224I, 224J, 224K and 224L and SM optical fibers 222A-222D. The remainder of the MM laser light which reaches 1XN SM beam splitter 206 is provided to isolator 208 and is either absorbed by isolator 208 or reflected back to 1XN SM beam splitter 206, since isolator 208 only enables laser light to flow in the direction of arrow 218. The laser light provided to MM optical fibers 224E, 224F, 224G and 224H is outputted. As shown, since plurality of MM slave laser diodes 202A-202D are multimode laser diodes, then plurality of outputs 214A-214D of respective ones of MM optical fibers 224E, 224F, 224G and 224H output multimode mode laser light.

Reference is now made to Figure 3C, which is another schematic illustration of a system for wavelength stabilization in a plurality of multimode laser diodes using a single mode laser diode, generally referenced 250, constructed and operative in accordance with a further embodiment of the disclosed technique. System 250 includes a plurality of multimode laser diodes 252A, 252B, 252C and 252D, a plurality of multimode 2X2 beam splitters 254A, 254B, 254C and 254D, an isolator 256, an FBG 258, a single mode laser diode 260, a beam dump 266, a plurality of multimode optical fibers 272A, 272B, 272C, 272D, 272E, 272F, 272G, 272H, 272I, 272J, 272K, 272L and 272M, single mode optical fibers 270A, 270B and 270C and a single mode to multimode optical fiber splice 268. Each one of plurality of multimode (MM) 2X2 beam splitters 254A-254D includes four ports. MM 2X2 beam splitter 254A includes ports 274A, 274B, 274C and 274D. MM 2X2 beam splitter 254B includes ports 274E, 274F, 274G and 274H. MM 2X2 beam splitter 254C includes ports 274I, 274J, 274K and 274L. MM 2X2 beam splitter 254D includes ports 274M, 274N, 2740 and 274P. Each one of plurality of MM 2X2 beam splitters 254A-254D is substantially similar in construction and design to MM 2X2 beam splitter 154 (Figure 3A), except that the ports on the sides of MM 2X2 beam splitters 254A-254D coupled with the MM laser diodes side are reversed.

MM laser diode 252A is coupled with port 274C via MM optical fiber 272H. Port 274A is coupled with beam dump 266 via MM optical fiber 2721. Port 274B is coupled with MM optical fiber 272J, which provides a multimode output 262A of MM laser light. MM laser diode 252B is coupled with port 274G via MM optical fiber 272F. Port 274F is coupled with MM optical fiber 272K, which provides a multimode output 262B of MM laser light. MM laser diode 252C is coupled with port 274K via MM optical fiber 272D. Port 274J is coupled with MM optical fiber 272L, which provides a multimode output 262C of MM laser light. MM laser diode 252D is coupled with port 2740 via MM optical fiber 272B. Port 274N is coupled with MM optical fiber 272M, which provides a multimode output 262D of MM laser light. Port 274P is coupled with MM optical fiber 272A. Ports 274D and 274E, which are respectively on MM 2X2 beam splitters 254A and 254B, are coupled with MM optical fiber 272G. Ports 274H and 2741, which are respectively on MM 2X2 beam splitters 254B and 254C, are coupled with MM optical fiber 272E. Ports 274L and 274M, which are respectively on MM 2X2 beam splitters 254C and 254D, are coupled with MM optical fiber 272C. FBG 258 is coupled with isolator 256 via SM optical fiber 270B, and with SM laser diode 260 via SM optical fiber 270C. Isolator 256 is coupled with SM optical fiber 270A. SM to MM optical fiber splice 268 couples SM optical fiber 270A to MM optical fiber 272A. It is noted that each of MM optical fiber 272J, 272K, 272L and 272M can be coupled with other elements (not shown) for further processing a laser beam before it is outputted. It is also noted that beam dump 266 is substantially similar to beam dump 162 (Figure 3A). It is also noted that beam dump 266 is an optional component in system 250. It is furthermore noted that FBG 258 is an optional component in system 250 if SM laser diode 260 is internally stabilized, for example by an internal Bragg grating (not shown) or by being thermally controlled (not shown). In another embodiment of the disclosed technique, in system 250 SM laser diode 260 and FBG 258 can together be replaced by another stabilized laser diode source. For example, SM laser diode 260 may be replaced by a multimode (MM) laser diode (not shown) and FBG 258 may be replaced by a volume Bragg grating (VBG). As another example, SM laser diode 260 may be replaced by a thermally stabilized MM laser diode, in which case FBG 258 is not needed. In both of these examples, SM optical fibers 270A, 270B and 270C would be replaced by MM optical fibers (not shown).

Isolator 256 enables laser light to pass through only in the direction depicted by an arrow 264, from FBG 258 to SM to MM optical fiber splice 268. The general flow of laser light in system 250 is depicted by the arrow heads on plurality of MM optical fibers 272A-272M and on SM optical fibers 270A-270C. As mentioned above, the splitting ratio of each of plurality of MM 2X2 beam splitters 254A-254D is such that one output port outputs a majority of the energy of the input laser beam, whereas the other output port outputs a small amount of energy of the input laser beam. In system 250, SM laser diode 260 can be referred to as a SM master laser diode or a SM seed laser diode, whereas each one of plurality of MM laser diodes 252A-252D can be referred to as a MM slave laser diode. In general, SM laser diode 260 can be any type of low power laser diode having a narrow and specific bandwidth, whereas each one of plurality of MM laser diodes 252A-252D can be any type of high power laser diode having a wide bandwidth. As described in further detail below, the light generated by SM master laser diode 260, which has a narrow bandwidth, is used to wavelength stabilize the light generated by each one of plurality of MM slave laser diodes 252A-252D. SM master laser diode 260 always operates in a CW mode. Each one of plurality of MM slave laser diodes 252A-252D can operate in a CW mode or a pulsed mode of operation. In general, each one of plurality of MM slave laser diodes 252A-252D is constantly being provided with laser light having a stable wavelength from SM master laser diode 260, thereby enabling each one of plurality of MM slave laser diodes 252A-252D to lock onto the wavelength of SM master laser diode 260 whether each one of plurality of MM slave laser diodes 252A-252D operates in a CW mode or a pulsed mode of operation.

Using system 250, a plurality of MM slave laser diodes can be wavelength stabilized using a single SM master laser diode while also reducing energy waste. In contrast to system 200 (Figure 3B), in which each MM 2X2 beam splitter was coupled with a respective beam dump, in system 250, an output and an input of each MM 2X2 beam splitter is daisy-chained, as explained in further detail below, such that only a single beam dump is required. It is noted that even though only four MM slave laser diodes are shown and described in Figure 3C, the laser setup in Figure 3C can be easily modified by a worker skilled in the art to accommodate a plurality of MM slave laser diodes being wavelength stabilized by a single SM master laser diode.

Plurality of MM slave laser diodes 252A-252D are wavelength stabilized as follows. SM master laser diode 260 provides SM laser light having a narrow bandwidth to FBG 258 via SM optical fiber 270C. FBG 258 provides most of the SM laser light to isolator 256 via SM optical fiber 270B, while reflecting a small portion of the SM laser light back to SM master laser diode 260. This is shown by the double headed arrow on SM optical fiber 270C and single headed arrow on SM optical fiber 270B. In one embodiment, FBG 258 is used to wavelength stabilize SM master laser diode 260. As such, SM master laser diode 260 can be a SM laser diode having a wide bandwidth, or a SM laser diode having a stable wavelength. In addition, the temperature of SM master laser diode 260 can be modified such that a specified wavelength of light is generated by SM master laser diode 260. Isolator 256 receives the SM laser light generated by SM master laser diode 260 and provides the SM laser light to SM optical fiber 270A. SM optical fiber 270A provides the SM laser light to MM optical fiber 272A via single mode to multimode optical fiber splice 268. When the SM laser light coming from isolator 256 is provided to MM optical fiber 272A, due to the increased size of the inner diameter (not shown) of MM optical fibers, the SM laser light may become MM laser light.

MM optical fiber 272A provides the laser light, either SM laser light or MM laser light, to port 274P of MM 2X2 beam splitter 254D. MM 2X2 beam splitter 254D splits the received laser beam such that, as per the example mentioned above, 95% of the laser beam is provided to port 274M and 5% of the laser beam is provided to port 2740. The 5% of the laser beam provided to port 2740 is provided to MM slave laser diode 252D, in order to wavelength stabilize it. The 95% of the laser beam provided to port 274M is provided via MM optical fiber 272C to port 274L of MM 2X2 beam splitter 254C. The 95% of the laser beam provided to port 274L is now split by MM 2X2 beam splitter 254C, such that 95% of the received laser beam (~90% of the original laser beam received from isolator 256) is provided to port 2741 and 5% of the received laser beam (~4.8% of the original laser beam received from isolator 256) is provided to port 274K. The 5% of the laser beam provided to port 274K is provided to MM slave laser diode 252C, in order to wavelength stabilize it. The 95% of the laser beam provided to port 2741 is provided via MM optical fiber 272E to port 274H of MM 2X2 beam splitter 254B. The 95% of the laser beam provided to port 274H is now split by MM 2X2 beam splitter 254B, such that 95% of the received laser beam (~86% of the original laser beam received from isolator 256) is provided to port 274E and 5% of the received laser beam (~4.5% of the original laser beam received from isolator 256) is provided to port 274G. The 5% of the laser beam provided to port 274G is provided to MM slave laser diode 252B, in order to wavelength stabilize it. The 95% of the laser beam provided to port 274E is provided via MM optical fiber 272G to port 274D of MM 2X2 beam splitter 254A. The 95% of the laser beam provided to port 274D is now split by MM 2X2 beam splitter 254A, such that 95% of the received laser beam (~81% of the original laser beam received from isolator 256) is provided to port 274A and 5% of the received laser beam (~4.3% of the original laser beam received from isolator 256) is provided to port 274C. The 5% of the laser beam provided to port 274C is provided to MM slave laser diode 252A, in order to wavelength stabilize it. The 95% of the laser beam provided to port 274A is provided via MM optical fiber 272A to beam dump 266. As shown in Figure 3C, due to the configuration of ports 274M, 274L, 2741, 274H, 274E and 274D, MM 2X2 beam splitters 254A-254D are substantially daisy-chained via MM optical fibers 272C, 272E and 272G. In contrast to Figure 3B, in which each MM 2X2 beam splitter receives a quarter of the energy of the SM laser light generated by SM master laser diode 212 (Figure 3B) since 1XN SM beam splitter 206 (Figure 3B) splits the energy of the SM laser light into four, in Figure 3C, each MM 2X2 beam splitter receives a substantially higher energy level laser beam from SM master laser diode 260 due to the daisy-chained arrangement of the MM 2X2 beam splitters. As shown on MM optical fiber 272I as a single headed arrow, beam dump 266 does not reflect any laser light back to MM 2X2 beam splitters 254A.

Plurality of MM slave laser diodes 252A-252D generate MM laser light having a wide bandwidth. Each one of MM slave laser diodes 252A-252D is operated simultaneously. As the 5% of the laser light generated by SM master laser diode 260 is provided to each one of plurality of MM slave laser diodes 252A-252D, the wavelength of MM light generated by each one of plurality of MM slave laser diodes 252A-252D locks onto the wavelength of light generated by SM master laser diode 260, as the light generated by SM master laser diode 260 is seed light provided to each one of plurality of MM slave laser diodes 252A-252D. It is noted that the MM laser light generated by each one of plurality of MM slave laser diodes 252A-252D will lock onto the wavelength of the light provided from SM master laser diode 260, whether the laser light provided to MM optical fiber 272A from isolator 256 remains SM laser light or becomes MM laser light. Each one of plurality of MM slave laser diodes 252A-252D provides its wavelength stabilized MM laser light respectively to ports 2740, 274K, 274G and 274C via respective ones of MM optical fibers 272B, 272D, 272F and 272H, as shown by the double headed arrows on MM optical fibers 272B, 272D, 272F and 272H. MM 2X2 beam splitter 254D receives the MM laser light from MM slave laser diode 252D and splits the received light, as per the example mentioned above, such that 95% of the MM laser light is provided as MM laser light to MM output 262D via port 274N and MM optical fiber 272M. MM 2X2 beam splitter 254C receives the MM laser light from MM slave laser diode 252C and splits the received light such that 95% of the MM laser light is provided as MM laser light to MM output 262C via port 274J and MM optical fiber 272L. MM 2X2 beam splitter 254B receives the MM laser light from MM slave laser diode 252B and splits the received light such that 95% of the MM laser light is provided as MM laser light to MM output 262B via port 274F and MM optical fiber 272K. MM 2X2 beam splitter 254A receives the MM laser light from MM slave laser diode 252A and splits the received light such that 95% of the MM laser light is provided as MM laser light to MM output 262A via port 274B and MM optical fiber 272J. 5% of the MM laser light beam provided to MM 2X2 beam splitter 254A from MM slave laser diode 252A is provided to port 274D, which provides the laser beam to MM 2X2 beam splitter 254B via port 274E. 5% of the MM laser light beam provided to MM 2X2 beam splitter 254B from MM slave laser diode 252B is provided to port 274H, which provides the laser beam to MM 2X2 beam splitter 254C via port 2741. 5% of the MM laser light beam provided to MM 2X2 beam splitter 254C from MM slave laser diode 252C is provided to port 274L, which provides the laser beam to MM 2X2 beam splitter 254D via port 274M. 5% of the MM laser light beam provided to MM 2X2 beam splitter 254D from MM slave laser diode 252D is provided to port 274P, which provides the laser beam to MM optical fiber 272A. The 5% of the MM laser beam provided by MM 2X2 beam splitters 254A, 254B and 254C to each of ports 274D, 274H and 274L respectively, is subsequently split, such that a first portion of the laser beam is outputted via one of MM optical fibers 272K, 272L or 272M, and a second portion of the laser beam is transferred eventually to MM 2X2 beam splitter 254D, which transfers the laser beam to MM optical fiber 272A.

SM to MM optical fiber splice 268 provides partial isolation of the MM laser light, as SM optical fiber 270A has a smaller inner diameter (not shown) than the inner diameter of MM optical fiber 272A, thereby preventing substantially most of the modes of the MM laser light in MM optical fiber 272A to be provided to SM optical fiber 270A. This flow of laser light is shown by the arrow heads on MM optical fiber 272A and SM optical fiber 270A. The remainder of the MM laser light which reaches isolator 256 is either absorbed by isolator 256 or reflected back to MM optical fiber 272A, since isolator 256 only enables laser light to flow in the direction of arrow 264. The laser light provided to MM optical fibers 272J, 272K, 272L and 272M is outputted. As shown, since plurality of MM slave laser diodes 252A-252D are multimode laser diodes, then plurality of outputs 262A-262D of respective ones of MM optical fibers 272J, 272K, 272L and 272M output multimode mode laser light.

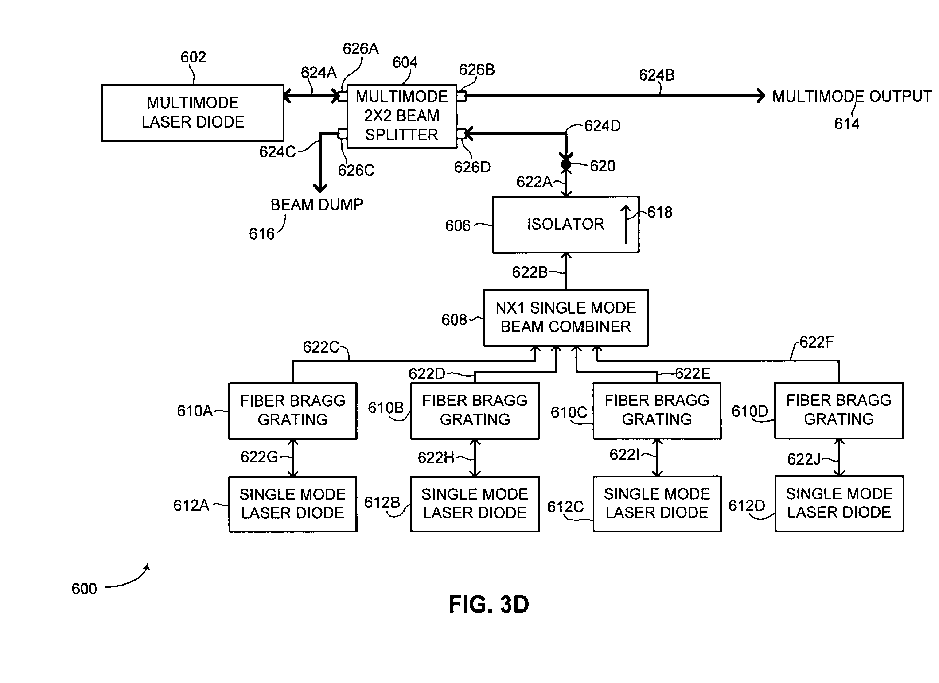

Reference is now made to Figure 3D, which is another schematic illustration of a system for wavelength stabilization in a multimode laser diode using a single mode to multimode splice, generally referenced 600, constructed and operative in accordance with another embodiment of the disclosed technique. System 600 includes a multimode laser diode 602, a multimode 2X2 beam splitter 604, an isolator 606, an NX1 SM beam combiner 608, a plurality of FBGs 610A, 610B, 610C and 610D, a plurality of single mode laser diodes 612A, 612B, 612C and 612D, a beam dump 616, multimode optical fibers 624A, 624B, 624C and 624D, a plurality of single mode optical fibers 622A, 622B, 622C, 622D, 622E, 622F, 622G, 622H, 622I and 622J and a single mode to multimode optical fiber splice 620. Multimode (MM) 2X2 beam splitter 604 includes four ports, labeled 626A, 626B, 626C and 626D. MM 2X2 beam splitter 604 is substantially similar in construction and design to MM 2X2 beam splitter 154 (Figure 3A). MM laser diode 602 is coupled with port 626A via MM optical fiber 624A. Port 626C is coupled with beam dump 616 via MM optical fiber 624C. Beam dump 616 is substantially similar to beam dump 162 (Figure 3A). Port 626B is coupled with MM optical fiber 624B, which provides a multimode output 614 of MM laser light. Each one of plurality of FBGs 610A, 610B, 610C and 610D is coupled with NX1 SM beam combiner 608 via plurality of SM optical fibers 622C, 622D, 622E and 622F respectively. Each one of plurality of SM laser diodes 612A, 612B, 612C and 612D is coupled respectively to FBGs 610A, 610B, 610C and 610D via plurality of SM optical fibers 622G, 622H, 622I and 622J respectively. Isolator 606 is coupled with NX1 SM beam combiner 608 via SM optical fiber 622B and with SM optical fiber 622A. Port 626D is coupled with MM optical fiber 624D. SM optical fiber 622A is coupled with MM optical fiber 624D via single mode to multimode optical fiber splice 620. It is noted that MM optical fiber 624B can be coupled with other elements (not shown) for further processing a laser beam before it is outputted. It is noted that beam dump 616 is an optional component in system 600. It is also noted that in one embodiment of the disclosed technique plurality of FBGs 610A-610D is optional. In this embodiment, each one of plurality of SM laser diodes 612A, 612B, 612C and 612D would be respectively coupled directly with NX1 SM beam combiner 608. Also in this embodiment, each one of plurality of SM laser diodes 612A, 612B, 612C and 612D would be a SM laser diode stabilized by either an internal Bragg grating (not shown), a thermal controller (not shown) or both. According to another embodiment, each one of plurality of SM laser diodes 612A-612D may each be replaced with a MM laser diode. In this embodiment, plurality of FBGs 610A-610D would be replaced with a plurality of volume Bragg gratings (VBGs) and NX1 SM beam combiner 608 would be replaced by an NX1 MM beam combiner. Isolator 606 would be coupled with MM 2X2 beam splitter 604 directly using a MM optical fiber and SM optical fibers 622B-622J would be replaced with MM optical fibers. The plurality of VBGs may be optional and the plurality of MM laser diodes could be coupled directly with the NX1 MM beam combiner directly if each one of the MM laser diodes has a stable wavelength.

Isolator 606 enables laser light to pass through only in the direction depicted by an arrow 618, from NX1 SM beam combiner 608 to SM optical fiber 622A. The general flow of laser light in system 600 is depicted by the arrow heads on MM optical fibers 624A-624D and plurality of SM optical fibers 622A-622J. As mentioned above, the splitting ratio of MM 2X2 beam splitter 604 is such that one output port outputs a majority of the energy of the input laser beam, whereas the other output port outputs a small amount of energy of the input laser beam. In system 600, each one of plurality of SM laser diodes 612A-612D can be referred to as a SM master laser diode or a SM seed laser diode, whereas MM laser diode 602 can be referred to as a MM slave laser diode. In general, each one of plurality of SM laser diodes 160 can be any type of low power laser diode having a narrow and specific bandwidth, whereas MM laser diode 602 can be any type of high power laser diode having a wide bandwidth. As described in further detail below, the light generated by any one of plurality of SM master laser diodes 612A-612D, which each have a narrow bandwidth, is used to wavelength stabilize the light generated by MM slave laser diode 602. Plurality of SM master laser diodes 612A-612D always operate in a CW mode. MM slave laser diode 602 can operate in a CW mode or a pulsed mode of operation. In general, MM slave laser diode 602 is constantly being provided with laser light having a stable wavelength from one of plurality of SM master laser diodes 612A-612D, thereby enabling MM slave laser diode 602 to lock onto the wavelength of one of plurality of SM master laser diodes 612A-612D whether MM slave laser diode 602 operates in a CW mode or a pulsed mode of operation.

As described above, in the system of Figures 3B and 3C, a single SM master laser diode can be used to wavelength stabilize a plurality of MM slave laser diodes. In system 600, a plurality of SM master laser diodes can be used to wavelength stabilize a MM slave laser diode. As mentioned above, the MM slave laser diodes used in the disclosed technique have a wide bandwidth. Using system 600, a single MM slave laser diode can be wavelength stabilized at a plurality of different wavelengths. As described below, each one of plurality of SM master laser diodes may have a different center wavelength and narrow bandwidth, within the bandwidth of MM slave laser diode. For example, MM slave laser diode 602 may have a bandwidth spanning from 972 nm to 980 nm. SM master laser diode 612A may have a narrow bandwidth such that it generates laser light between 974.0 nm and 974.2 nm. SM master laser diode 612B may have a narrow bandwidth such that it generates laser light between 975.0 nm and 975.2 nm. SM master laser diode 612C may have a narrow bandwidth such that it generates laser light between 976.0 nm and 976.2 nm. SM master laser diode 612D may have a narrow bandwidth such that it generates laser light between 977.0 nm and 977.2 nm. In turn, MM slave laser diode 602 may be wavelength stabilized at each of the following wavelengths ranges: between 974.0-974.2 nm, between 975.0-975.2 nm, between 976.0-976.2 nm and between 977.0-977.2 nm, depending on which one of plurality of SM master laser diodes 612A-612D is used to wavelength stabilize MM slave laser diode 602. In addition, MM slave laser diode 602 may have a bandwidth spanning from 803 nm to 813 nm, with each one of SM master laser diodes 612A-612D having a narrower bandwidth within the range of 803-813 nm, for wavelength stabilizing MM slave laser diode 602 at a more narrower wavelength range, for example, between 808.0-808.1 nm.

MM slave laser diode 602 is wavelength stabilized as follows. As per a user's selection, one of plurality of SM master laser diodes 612A-61 D provides SM laser light having a narrow bandwidth to a respective one of plurality of FBGs 610A-610D via SM optical fiber 622G, 622H, 622I and 622J respectively. FBGs 610A-610D provide most of the SM laser light to NX1 SM beam combiner 608 via SM optical fibers 622C, 622D, 622E and 622F respectively, while reflecting a small portion of the SM laser light back respectively to plurality of SM master laser diodes 612A-612D. This is shown by the double headed arrows on SM optical fibers 622G, 622H, 622I and 622J, and single headed arrows on SM optical fibers 622C, 622D, 622E and 622F. Plurality of FBGs 610A-610D is used to wavelength stabilize plurality of SM master laser diodes 612A-612D. As such, each one of plurality of SM master laser diodes 612A-612D can either be a SM laser diode having a wide bandwidth or a SM laser diode having a stable wavelength. In either case, the temperature of each of plurality of SM master laser diodes 612A-612D can be modified such that a specified wavelength of light is generated by each of plurality of SM master laser diodes 612A-612D. Also, as mentioned above, plurality of FBGs 610A-610D may be optional components. In system 600, plurality of SM master laser diodes 612A-612D are not operated simultaneously, rather, a single SM master laser diode is operated at any given time. NX1 SM beam combiner 608 receives the laser beams of light provided by each of SM optical fibers 622C, 622D, 622E and 622F. NX1 SM beam combiner 608 then provides the received SM laser beam of light and provides it to isolator 606 via SM optical fiber 622B. Even though NX1 SM beam combiner 608 is capable of combining a plurality of received laser beams into a single laser beam, since only one of plurality of SM master laser diodes 612A-612D is used at any given time, NX1 SM beam combiner 608 operates substantially as a switch for coupling the laser light generated by each of SM master laser diodes 612A-612D to isolator 606. Isolator 606 receives the SM laser light generated by one of plurality of SM master laser diodes 612A-612D and provides the SM laser light to SM optical fiber 622A. SM optical fiber 622A provides the SM laser light to MM optical fiber 624D via single mode to multimode optical fiber splice 620. When the SM laser light coming from isolator 606 is provided to MM optical fiber 624D, due to the increased size of the inner diameter (not shown) of MM optical fibers, the SM laser light may become MM laser light. MM optical fiber 624D provides the laser light, either SM laser light or MM laser light, to port 626D of MM 2X2 beam splitter 604. MM 2X2 beam splitter 604 splits the received laser beam such that, as per the example mentioned above, 95% of the laser beam is provided to port 626C and 5% of the laser beam is provided to port 626A. The 95% of the laser beam provided to port 626C is provided via MM optical fiber 624C to beam dump 616. As shown on MM optical fiber 624C as a single headed arrow, beam dump 616 does not reflect any laser light back to MM 2X2 beam splitter 604. The 5% of the laser beam provided to port 626A is provided, via MM optical fiber 624A, to MM slave laser diode 602.

MM slave laser diode 602 generates MM laser light having a wide bandwidth. As the 5% of the laser light generated by one of plurality of SM master laser diodes 612A-612D is provided to MM slave laser diode 602, the wavelength of MM light generated by MM slave laser diode 602 locks onto the wavelength of light generated by one of plurality of SM master laser diodes 612A-612D, as the light generated by one of plurality of SM master laser diodes 612A-612D is a seed light provided to MM slave laser diode 602. It is noted that the MM laser light generated by MM slave laser diode 602 will lock onto the wavelength of the light provided from one of plurality of SM master laser diodes 612A-612D, whether the laser light provided to MM optical fiber 624D from isolator 606 remains SM laser light or becomes MM laser light. MM slave laser diode 602 provides its wavelength stabilized MM laser light to port 626A via MM optical fiber 624A, as shown by the double headed arrow on MM optical fiber 624A. MM 2X2 beam splitter 604 receives the MM laser light from MM slave laser diode 602 and splits the received light, as per the example mentioned above, such that 95% of the MM laser light is provided as MM laser light to MM output 614 via port 626B and MM optical fiber 624B. 5% of the MM laser light is provided to isolator 606 via port 626D and MM optical fiber 624D. Single mode to multimode optical fiber splice 620 provides partial isolation of the MM laser light, as SM optical fiber 622A has a smaller inner diameter (not shown) than the inner diameter of MM optical fiber 624D, thereby preventing substantially most of the modes of the MM laser light in MM optical fiber 624D to be provided to SM optical fiber 622A. This flow of laser light is shown by the arrow heads on MM optical fiber 624D and SM optical fiber 622A. The remainder of the MM laser light which reaches isolator 606 is either absorbed by isolator 606 or reflected back to MM 2X2 beam splitter 604, since isolator 606 only enables laser light to flow in the direction of arrow 618. The laser light provided to MM optical fiber 624B is outputted. As shown, since MM slave laser diode 602 is a multimode laser diode, then an output 614 of MM optical fiber 624B is a multimode mode laser light.

Reference is now made to Figure 4A, which is a further schematic illustration of a system for wavelength stabilization in a multimode laser diode using a fiber Bragg grating, generally referenced 300, constructed and operative in accordance with a further embodiment of the disclosed technique. System 300 includes a multimode laser diode 302, a multimode 2X2 beam splitter 304, a high reflection fiber Bragg grating (herein abbreviated HRFBG) 306, a first beam dump 308, a second beam dump 310, multimode optical fibers 318A, 318B, 318C and 318D, single mode optical fibers 316A and 316B and a single mode to multimode optical fiber splice 314. Multimode (MM) 2X2 beam splitter 304 includes four ports, labeled 320A, 320B, 320C and 320D. MM 2X2 beam splitter 304 is substantially similar in construction and design to MM 2X2 beam splitter 154 (Figure 3A). MM laser diode 302 is coupled with port 320A via MM optical fiber 318A. Port 320B is coupled with second beam dump 310 via MM optical fiber 318D. Second beam dump 310 is substantially similar to beam dump 162 (Figure 3A). Port 320C is coupled with MM optical fiber 318B, which provides a multimode output 312 of MM laser light. Port 320D is coupled with MM optical fiber 318C. HRFBG 306 is coupled with SM optical fibers 316A and 316B. SM optical fiber 316A is coupled with MM optical fiber 318C via single mode to multimode optical fiber splice 314. HRFBG 306 is coupled with first beam dump 308 via SM optical fiber 316B. It is noted that MM optical fiber 318B can be coupled with other elements (not shown) for further processing a laser beam before it is outputted. It is also noted that each of first beam dump 308 and second beam dump 310 are optional components in system 300. In addition it is noted that in another embodiment of the disclosed technique, using the setup of the system shown in Figure 4A, SM optical fibers 316A and 316B can be replaced by large mode area (LMA) optical fibers (not shown). In such an embodiment, SM to MM optical fiber splice 314 would be replaced by an LMA to MM optical fiber splice (not shown). In a further embodiment of the disclosed technique, HRFBG 306 can be replaced by a high reflection volume Bragg grating (herein abbreviated HRVBG). In this embodiment, SM optical fibers 316A and 316B would be replaced by MM optical fibers (not shown) and SM to MM optical fiber splice 314 would be replaced by a MM to MM optical fiber splice (not shown). As an alternative to this embodiment, port 320D may be coupled directly with the HRVBG via a MM optical fiber (not shown), thereby obviating the need for an optical fiber splice and thus saving energy.

HRFBG 306 reflects a large portion of the laser light provided to it in a specific narrow bandwidth, while enabling a small portion in the specific narrow bandwidth and substantially all laser light outside the specific narrow bandwidth to pass through it. The general flow of laser light in system 300 is depicted by the arrow heads on MM optical fibers 318A-318D and SM optical fibers 316A-316B. As mentioned above, the splitting ratio of MM 2X2 beam splitter 304 is such that one output port outputs a majority of the energy of the input laser beam, whereas the other output port outputs a small amount of energy of the input laser beam. In system 300, MM laser diode 302 is provided feedback from HRFBG 306. In general, MM laser diode 302 can be any type of high power laser diode having a wide bandwidth. As described in further detail below, a portion of the light generated by MM laser diode 302 is reflected by HRFBG 306 and used to wavelength stabilize the light generated by MM laser diode 302. MM laser diode 302 can operate in a CW mode or a pulsed mode (provided that the pulse width of the light outputted by MM laser diode 302 is longer than the time it takes light to travel from MM laser diode 302 to HRFBG 306 and back to MM laser diode 302). In general, MM laser diode 302 is constantly being provided with laser light having a stable wavelength, reflected from HRFBG 306, thereby enabling MM laser diode 302 to lock onto the wavelength of the reflected beam of light whether the reflected light is a continuous beam of light or a pulsed beam of light.

MM laser diode 302 is wavelength stabilized as follows. MM laser diode 302 generates MM laser light having a wide bandwidth and provides the MM laser light to port 320A of MM 2X2 beam splitter 304 via MM optical fiber 318A. MM 2X2 beam splitter 304 splits the received laser beam such that, as per the example mentioned above, 95% of the laser beam is provided to port 320C and 5% of the laser beam is provided to port 320D. The 5% of the laser beam provided to port 320D is provided via MM optical fiber 318C, SM to MM optical fiber splice 314 and SM optical fiber 316A to HRFBG 306. HRFBG 306 reflects a large portion of the laser light received which is in a specific narrow bandwidth back to port 320D. For example, HRFBG 306 may reflect most of the laser light it receives which has a wavelength between 975 nm and 976 nm, while letting laser light at other wavelengths pass through it. The laser light which passes through HRFBG 306 is provided via SM optical fiber 316B to first beam dump 308. First beam dump is substantially similar to beam dump 162 (Figure 3A). As shown on SM optical fiber 316B as a single headed arrow, first beam dump 308 does not reflect any laser light back to HRFBG 306. It is noted that as laser light is provided from MM optical fiber 318C to SM optical fiber 316A, the MM laser light in MM optical fiber 318C substantially becomes SM laser light. It is noted that a significant amount of loss in the energy of the MM laser light may occur when it becomes SM laser light. As mentioned above, according to another embodiment of the disclosed technique, SM optical fibers 316A and 316B are replaced by LMA optical fibers and SM to MM optical fiber splice 314 is replaced by a LMA to MM optical fiber splice. In such an embodiment, when the MM laser light is converted into LMA laser light, a significantly smaller amount of loss of energy in the MM laser light occurs. According to another embodiment of the disclosed technique, as mentioned above, an HRVBG is used instead of HRFBG 306 and SM optical fibers 316A and 316B are replaced by MM optical fibers, thereby making the loss of energy due to splicing even smaller.

The laser light reflected by HRFBG 306 is provided via SM optical fiber 316A, SM to MM optical fiber splice 314 and MM optical fiber 318C to port 320D. When the SM laser light reflected from HRFBG 306 is provided to MM optical fiber 318C, due to the increased size of the inner diameter (not shown) of MM optical fibers, the SM laser light may become MM laser light. MM optical fiber 318C provides the laser light, either SM laser light or MM laser light, to port 320D of MM 2X2 beam splitter 304. MM 2X2 beam splitter 304 splits the received laser beam such that 95% of the laser beam is provided to port 320B and 5% of the laser beam is provided to port 320A. The 95% of the laser beam provided to port 320B is provided via MM optical fiber 318D to second beam dump 310. As shown on MM optical fiber 318D as a single headed arrow, beam dump 310 does not reflect any laser light back to MM 2X2 beam splitter 304. The 5% of the laser beam provided to port 320A is provided, via MM optical fiber 318A, to MM laser diode 302. The 5% of the laser light reflected from HRFBG 306 is used to lock the wavelength of MM light generated by MM laser diode 302. The light reflected from HRFBG 306 is substantially 'feedback' provided to MM laser diode 302 to stabilize its wavelength. It is noted that the MM laser light generated by MM laser diode 302 will lock onto the wavelength of the light reflected from HRFBG 306, whether the laser light reflected to MM optical fiber 318C remains SM laser light or becomes MM laser light. MM laser diode 302 provides its wavelength stabilized MM laser light to port 320A via MM optical fiber 318A, as shown by the double headed arrow on MM optical fiber 318A. MM 2X2 beam splitter 304 receives the MM laser light from MM laser diode 302 and splits the received light such that 95% of the MM laser light is provided as MM laser light to MM output 312 via port 320C and MM optical fiber 318B. 5% of the MM laser light is provided to HRFBG 306 via port 320D and MM optical fiber 318C. The remainder of the MM laser light which reaches HRFBG 306 is either allowed to pass through or is reflected back to MM 2X2 beam splitter 304. The laser light provided to MM optical fiber 318B is outputted. As shown, since MM laser diode 302 is a multimode laser diode, then an output 312 of MM optical fiber 318B is a multimode mode laser light. In contrast to system 150 (Figure 3A), system 300 does not require the use of a SM master laser diode to wavelength stabilize a MM laser diode.

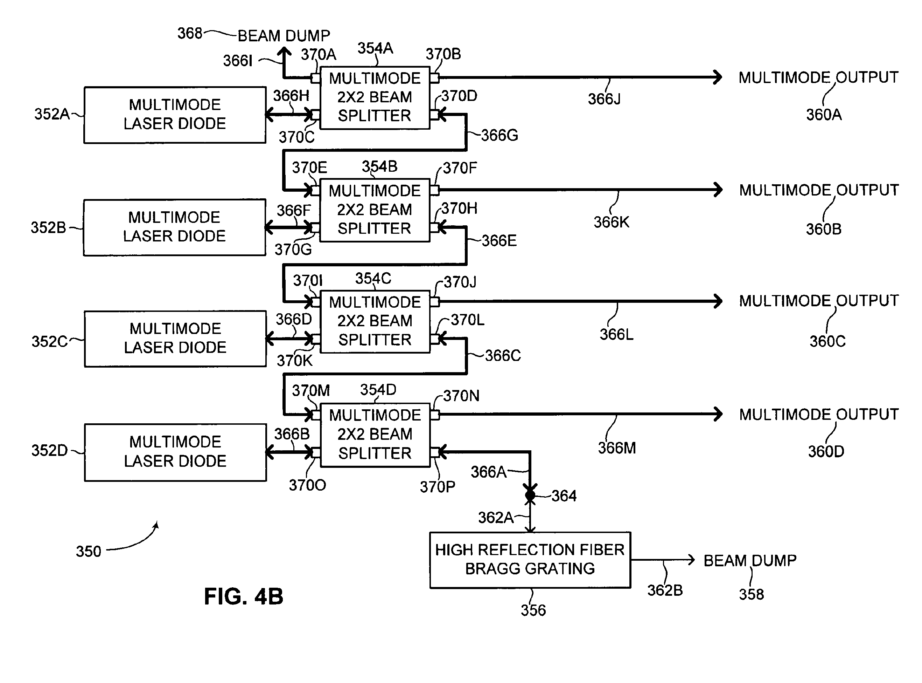

Reference is now made to Figure 4B, which is a further schematic illustration of a system for wavelength stabilization in a plurality of multimode laser diodes using a fiber Bragg grating, generally referenced 350, constructed and operative in accordance with another embodiment of the disclosed technique. System 350 includes a plurality of multimode laser diodes 352A, 352B, 352C and 352D, a plurality of multimode 2X2 beam splitters 354A, 354B, 354C and 354D, a high reflection fiber Bragg grating (herein abbreviated HRFBG) 356, a first beam dump 358, a second beam dump 368, a plurality of multimode optical fibers 366A, 366B, 366C, 366D, 366E, 366F, 366G, 366H, 366I, 366J, 366K, 366L and 366M, single mode optical fibers 362A and 362B and a single mode to multimode optical fiber splice 364. In another embodiment of the disclosed technique, large mode area (LMA) optical fibers (not shown) are substituted for SM optical fibers 362A and 362B and an LMA to multimode optical fiber splice is substituted for SM to MM optical fiber splice 364. Each one of plurality of multimode (MM) 2X2 beam splitters 354A-354D includes four ports. MM 2X2 beam splitter 354A includes ports 370A, 370B, 370C and 370D. MM 2X2 beam splitter 354B includes ports 370E, 370F, 370G and 370H. MM 2X2 beam splitter 354C includes ports 370I, 370J, 370K and 370L. MM 2X2 beam splitter 354D includes ports 370M, 370N, 3700 and 370P. Each one of plurality of MM 2X2 beam splitters 354A-354D is substantially similar in construction and design to MM 2X2 beam splitter 254A (Figure 3C). In a further embodiment of the disclosed technique, HRFBG 356 is replaced by a high reflection volume Bragg grating (herein abbreviated HRVBG) which is coupled directly with port 370P via a MM optical fiber (not shown). In this embodiment, SM optical fiber 362B would be replaced by a MM optical fiber and SM to MM optical fiber splice 364 would be removed as it would be unnecessary in such an embodiment.

MM laser diode 352A is coupled with port 370C via MM optical fiber 366H. Port 370A is coupled with second beam dump 368 via MM optical fiber 3661. Port 370B is coupled with MM optical fiber 366J, which provides a multimode output 360A of MM laser light. MM laser diode 352B is coupled with port 370G via MM optical fiber 366F. Port 370F is coupled with MM optical fiber 366K, which provides a multimode output 360B of MM laser light. MM laser diode 352C is coupled with port 370K via MM optical fiber 366D. Port 370J is coupled with MM optical fiber 366L, which provides a multimode output 360C of MM laser light. MM laser diode 352D is coupled with port 3700 via MM optical fiber 366B. Port 370N is coupled with MM optical fiber 366M, which provides a multimode output 360D of MM laser light. Port 370P is coupled with MM optical fiber 366A. Ports 370D and 370E, which are respectively on MM 2X2 beam splitters 354A and 354B, are coupled with MM optical fiber 366G. Ports 370H and 3701, which are respectively on MM 2X2 beam splitters 354B and 354C, are coupled with MM optical fiber 366E. Ports 370L and 370M, which are respectively on MM 2X2 beam splitters 354C and 354D, are coupled with MM optical fiber 366C. HRFBG 356 is coupled with SM optical fiber 362A and SM optical fiber 362B. SM optical fiber 362B is coupled with first beam dump 358. SM to MM optical fiber splice 364 couples SM optical fiber 362A to MM optical fiber 366A. It is noted that each of MM optical fiber 366J, 366K, 366L and 366M can be coupled with other elements (not shown) for further processing a laser beam before it is outputted. It is also noted that second beam dump 368 is substantially similar to beam dump 162 (Figure 3A). It is also noted that second beam dump 368 is an optional component in system 350.

HRFBG 356 reflects a large portion of the laser light provided to it in a specific narrow bandwidth, while enabling a small portion in the specific narrow bandwidth and substantially all laser light outside the specific narrow bandwidth to pass through it. The general flow of laser light in system 350 is depicted by the arrow heads on plurality of MM optical fibers 366A-366M and on SM optical fibers 362A-362B. As mentioned above, the splitting ratio of each of plurality of MM 2X2 beam splitters 354A-354D is such that one output port outputs a majority of the energy of the input laser beam, whereas the other output port outputs a small amount of energy of the input laser beam. In system 350, each one of plurality of MM laser diodes 352A-352D is provided feedback from HRFBG 356. In general each one of plurality of MM laser diodes 352A-352D can be any type of high power laser diode having a wide bandwidth. Each one of plurality of MM laser diodes 352A-352D can operate in a CW mode or a pulsed mode (provided that the pulse width of the light outputted by any one of plurality of MM laser diodes 352A-352D is significantly longer than the time it takes light to travel from MM laser diode 352D to HRFBG 356 and back to MM laser diode 352D). As described in further detail below, a portion of the light generated by each one of plurality of MM laser diodes 352A-352D is reflected by HRFBG 356 and used to wavelength stabilize the light generated by each one of plurality of MM laser diodes 352A-352D. In general, each one of plurality of MM laser diodes 352A-352D is constantly being provided with laser light having a stable wavelength, reflected from HRFBG 356, thereby enabling each one of plurality of MM laser diodes 352A-352D to lock onto the wavelength of the reflected beam of light, whether the reflected light is a continuous beam of light or a pulsed beam of light.

Using system 350, a plurality of MM laser diodes can be wavelength stabilized using an HRFBG while also reducing energy waste. In system 350, an output and an input of each MM 2X2 beam splitter is daisy-chained, as explained in further detail below, such that only a single beam dump is required. It is noted that even though only four MM laser diodes are shown and described in Figure 4B, the laser setup in Figure 4B can be easily modified by a worker skilled in the art to accommodate a plurality of MM laser diodes being wavelength stabilized by a single HRFBG.

Plurality of MM laser diodes 352A-352D are wavelength stabilized as follows. Plurality of MM laser diodes 352A-352D generate MM laser light having a wide bandwidth. Each one of MM laser diodes 352A-352D is operated simultaneously. MM laser diode 352D provides the MM laser light to port 3700 of MM 2X2 beam splitter 354D via MM optical fiber 366B. MM 2X2 beam splitter 354D splits the received laser beam such that 95% of the laser beam is provided to port 370N and 5% of the laser beam is provided to port 370P. MM laser diode 352C provides the MM laser light to port 370K of MM 2X2 beam splitter 354C via MM optical fiber 366D. MM 2X2 beam splitter 354C splits the received laser beam such that 95% of the laser beam is provided to port 370J and 5% of the laser beam is provided to port 370L. MM laser diode 352B provides the MM laser light to port 370G of MM 2X2 beam splitter 354B via MM optical fiber 366F. MM 2X2 beam splitter 354B splits the received laser beam such that 95% of the laser beam is provided to port 370F and 5% of the laser beam is provided to port 370H. MM laser diode 352A provides the MM laser light to port 370C of MM 2X2 beam splitter 354A via MM optical fiber 366H. MM 2X2 beam splitter 354A splits the received laser beam such that 95% of the laser beam is provided to port 370B and 5% of the laser beam is provided to port 370D.

The 5% of the laser beam provided to port 370P is provided via MM optical fiber 366A, SM to MM optical fiber splice 364 and SM optical fiber 362A to HRFBG 356. The 5% of the laser beam provided to port 370L is provided to port 370M of MM 2X2 beam splitter 354D. The 5% of the laser beam provided to port 370H is provided to port 3701 of MM 2X2 beam splitter 354C. The 5% of the laser beam provided to port 370D is provided to port 370E of MM 2X2 beam splitter 354B. The 5% of the MM laser beam provided by MM 2X2 beam splitters 354A, 354B and 354C to each of ports 370D, 370H and 370L respectively, is subsequently split, such that a first portion of the laser beam is outputted via one of MM optical fibers 366K, 366L or 366M, and a second portion of the laser beam is transferred eventually to MM 2X2 beam splitter 354D, which transfers the laser beam to MM optical fiber 366A. HRFBG 356 reflects a large portion of the laser light received which is in a specific narrow bandwidth back to port 370P. The laser light which passes through HRFBG 356 is provided via SM optical fiber 362B to first beam dump 358. First beam dump is substantially similar to beam dump 162 (Figure 3A). As shown on SM optical fiber 362B as a single headed arrow, first beam dump 358 does not reflect any laser light back to HRFBG 356. It is noted that as laser light is provided from MM optical fiber 366A to SM optical fiber 362A, the MM laser light in MM optical fiber 366A substantially becomes SM laser light. It is noted that a significant amount of loss in the energy of the MM laser light may occur when it becomes SM laser light. As mentioned above, according to another embodiment of the disclosed technique, SM optical fibers 362A and 362B are replaced by LMA optical fibers and SM to MM optical fiber splice 364 is replaced by a LMA to MM optical fiber splice. In such an embodiment, when the MM laser light is converted into LMA laser light, a significantly smaller amount of loss of energy in the MM laser light occurs. As mentioned above, according to a further embodiment of the disclosed technique, HRFBG 356 is replaced by an HRVBG (not shown), SM optical fibers 362A and 362B are replaced by MM optical fibers and SM to MM optical fiber splice 364 is removed from such a system as the HRVBG can be coupled directly with MM 2X2 beam splitter 354D via an MM optical fiber (not shown). In such an embodiment, a negligible amount of loss of energy may occur when the MM laser light from port 370P is provided to the HRVBG.

The laser light reflected by HRFBG 356 is provided via SM optical fiber 362A, SM to MM optical fiber splice 364 and MM optical fiber 366A to port 370P. When the SM laser light reflected from HRFBG 356 is provided to MM optical fiber 366A, due to the increased size of the inner diameter (not shown) of MM optical fibers, the SM laser light may become MM laser light. MM optical fiber 366A provides the laser light, either SM laser light or MM laser light, to port 370P of MM 2X2 beam splitter 354D. MM 2X2 beam splitter 354D splits the received laser beam such that 95% of the laser beam is provided to port 370M and 5% of the laser beam is provided to port 3700. The 5% of the laser beam provided to port 3700 is provided to MM laser diode 352D, in order to wavelength stabilize it. The 95% of the laser beam provided to port 370M is provided via MM optical fiber 366C to port 370L of MM 2X2 beam splitter 354C. The 95% of the laser beam provided to port 370L is now split by MM 2X2 beam splitter 354C, such that 95% of the received laser beam (∼90% of the reflected laser beam received from HRFBG 356) is provided to port 370I and 5% of the received laser beam (∼4.8% of the reflected laser beam received from HRFBG 356) is provided to port 370K. The 5% of the laser beam provided to port 370K is provided to MM laser diode 352C, in order to wavelength stabilize it. The 95% of the laser beam provided to port 3701 is provided via MM optical fiber 366E to port 370H of MM 2X2 beam splitter 354B. The 95% of the laser beam provided to port 370H is now split by MM 2X2 beam splitter 354B, such that 95% of the received laser beam (∼86% of the reflected laser beam received from HRFBG 356) is provided to port 370E and 5% of the received laser beam (∼4.5% of the reflected laser beam received from HRFBG 356) is provided to port 370G. The 5% of the laser beam provided to port 370G is provided to MM laser diode 352B, in order to wavelength stabilize it. The 95% of the laser beam provided to port 370E is provided via MM optical fiber 366G to port 370D of MM 2X2 beam splitter 354A. The 95% of the laser beam provided to port 370D is now split by MM 2X2 beam splitter 354A, such that 95% of the received laser beam (∼81% of the reflected laser beam received from HRFBG 356) is provided to port 370A and 5% of the received laser beam (∼4.3% of the reflected laser beam received from HRFBG 356) is provided to port 370C. The 5% of the laser beam provided to port 370C is provided to MM laser diode 352A, in order to wavelength stabilize it. The 95% of the laser beam provided to port 370A is provided via MM optical fiber 366A to second beam dump 368. As shown in Figure 4B, due to the configuration of ports 370M, 370L, 370I, 370H, 370E and 370D, MM 2X2 beam splitters 354A-354D are substantially daisy-chained via MM optical fibers 366C, 366E and 366G. As shown on MM optical fiber 366I as a single headed arrow, second beam dump 368 does not reflect any laser light back to MM 2X2 beam splitters 354A.

In system 350, the light reflected from HRFBG 356 is substantially 'feedback' provided to each one of plurality of MM laser diodes 352A-352D to stabilize its wavelength. It is noted that the MM laser light generated by each one of plurality of MM laser diodes 352A-352D will lock onto the wavelength of the light reflected from HRFBG 356, whether the laser light reflected to MM optical fiber 366A remains SM laser light or becomes MM laser light. Each one of plurality of MM laser diodes 352A-352D provides its wavelength stabilized MM laser light respectively to ports 3700, 370K, 370G and 370C via respective ones of MM optical fibers 366B, 366D, 366F and 366H, as shown by the double headed arrows on MM optical fibers 366B, 366D, 366F and 366H. MM 2X2 beam splitter 354D receives the wavelength stabilized MM laser light from MM laser diode 352D and splits the received light, as per the example mentioned above, such that 95% of the MM laser light is provided as MM laser light to MM output 360D via port 370N and MM optical fiber 366M. MM 2X2 beam splitter 354C receives the wavelength stabilized MM laser light from MM laser diode 352C and splits the received light such that 95% of the MM laser light is provided as MM laser light to MM output 360C via port 370J and MM optical fiber 366L. MM 2X2 beam splitter 354B receives the wavelength stabilized MM laser light from MM laser diode 352B and splits the received light such that 95% of the MM laser light is provided as MM laser light to MM output 360B via port 370F and MM optical fiber 366K. MM 2X2 beam splitter 354A receives the wavelength stabilized MM laser light from MM laser diode 352A and splits the received light such that 95% of the MM laser light is provided as MM laser light to MM output 360A via port 370B and MM optical fiber 366J.

5% of the MM laser light beam provided to MM 2X2 beam splitter 354A from MM laser diode 352A is provided to port 370D, which provides the laser beam to MM 2X2 beam splitter 354B via port 370E. 5% of the MM laser light beam provided to MM 2X2 beam splitter 354B from MM laser diode 352B is provided to port 370H, which provides the laser beam to MM 2X2 beam splitter 354C via port 3701. 5% of the MM laser light beam provided to MM 2X2 beam splitter 354C from MM laser diode 352C is provided to port 370L, which provides the laser beam to MM 2X2 beam splitter 354D via port 370M. 5% of the MM laser light beam provided to MM 2X2 beam splitter 354D from MM laser diode 352D is provided to port 370P, which provides the laser beam to MM optical fiber 366A. The remainder of the MM laser light which reaches HRFBG 356 is either passed to first beam dump 358 or reflected back to MM optical fiber 366A. The laser light provided to MM optical fibers 366J, 366K, 366L and 366M is outputted. As shown, since plurality of MM laser diodes 352A-352D are multimode laser diodes, then plurality of outputs 360A-360D of respective ones of MM optical fibers 366J, 366K, 366L and 366M output multimode mode laser light. In contrast to system 250 (Figure 3C), system 350 does not require the use of a SM master laser diode to wavelength stabilize a plurality of MM laser diodes.

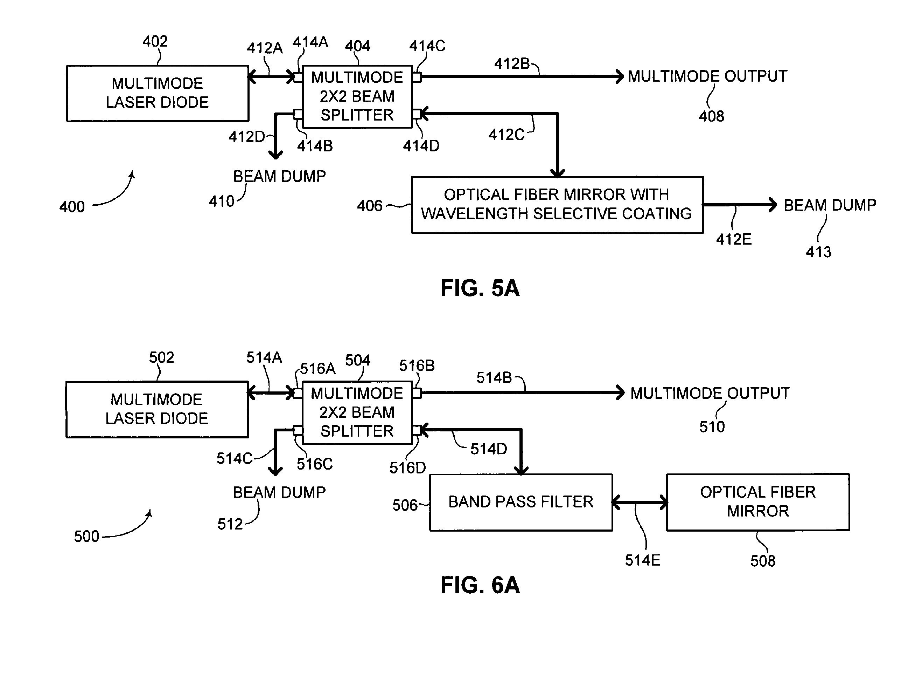

Reference is now made to Figure 5A, which is a schematic illustration of a system for wavelength stabilization in a multimode laser diode using a coated optical fiber mirror, generally referenced 400, constructed and operative in accordance with a further embodiment of the disclosed technique. System 400 includes a multimode laser diode 402, a multimode 2X2 beam splitter 404, an optical fiber mirror (herein abbreviated OFM) 406, a first beam dump 410, a second beam dump 413 and multimode optical fibers 412A, 412B, 412C, 412D and 412E. Multimode (MM) 2X2 beam splitter 404 includes four ports, labeled 414A, 414B, 414C and 414D. MM 2X2 beam splitter 404 is substantially similar in construction and design to MM 2X2 beam splitter 154 (Figure 3A). MM laser diode 402 is coupled with port 414A via MM optical fiber 412A. Port 414B is coupled with first beam dump 410 via MM optical fiber 412D. First beam dump 410 is substantially similar to beam dump 162 (Figure 3A). Port 414C is coupled with MM optical fiber 412B, which provides a multimode output 408 of MM laser light. Port 414D is coupled with OFM 406 via MM optical fiber 412C. OFM 406 is constructed having a wavelength selective coating. OFM 406 is coupled with second beam dump 413 via MM optical fiber 412E. Second beam dump 413 is substantially similar to beam dump 162. Laser beams impinging on OFM 406 having a wavelength falling in the range of wavelengths defined by the selective coating are substantially completely reflected, whereas laser beams impinging on OFM 406 having a wavelength falling out of the range of wavelengths defined by the selective coating are substantially transmitted (or absorbed) via MM optical fiber 412E to second beam dump 413. It is noted that MM optical fiber 412B can be coupled with other elements (not shown) for further processing a laser beam before it is outputted. It is also noted that first beam dump 410 and second beam dump 413 are optional components in system 400.

The general flow of laser light in system 400 is depicted by the arrow heads on MM optical fibers 412A-412E. As mentioned above, the splitting ratio of MM 2X2 beam splitter 404 is such that one output port outputs a majority of the energy of the input laser beam, whereas the other output port outputs a small amount of energy of the input laser beam. In system 400, MM laser diode 402 is provided feedback from OFM 406. In general, MM laser diode 402 can be any type of high power laser diode having a wide bandwidth. As described in further detail below, a portion of the light generated by MM laser diode 402 is reflected by OFM and used to wavelength stabilize the light generated by MM laser diode 402. MM laser diode 402 can operate in a CW mode or a pulsed mode (provided that the pulse width of the light outputted by MM laser diode 402 is longer than the time it takes light to travel from MM laser diode 402 to OFM 406 and back to MM laser diode 402). In general, MM laser diode 402 is constantly being provided with laser light having a stable wavelength, reflected from OFM 406, thereby enabling MM laser diode 402 to lock onto the wavelength of the reflected beam of light, whether the reflected light is a continuous beam of light or a pulsed beam of light.

MM laser diode 402 is wavelength stabilized as follows. MM laser diode 402 generates MM laser light having a wide bandwidth and provides the MM laser light to port 414A of MM 2X2 beam splitter 404 via MM optical fiber 412A. MM 2X2 beam splitter 404 splits the received laser beam such that 95% of the laser beam is provided to port 414C and 5% of the laser beam is provided to port 414D. The 5% of the laser beam provided to port 414D is provided via MM optical fiber 412C to OFM 406. OFM 406 substantially completely reflects the portion of the laser light received which is in the range of the selective coating back to port 414D. For example, OFM 406 may reflect substantially all the laser light it receives which has a wavelength between 972 nm and 980 nm, while transmitting substantially all the received laser light at other wavelengths to second beam dump 413 via MM optical fiber 412E. As shown on MM optical fiber 412E as a single headed arrow, second beam dump 413 does not reflect any laser light back to OFM 406.

The laser light reflected by OFM 406 is provided via MM optical fiber 412C to port 414D, which provides the MM laser light to MM 2X2 beam splitter 404. MM 2X2 beam splitter 404 splits the received MM laser beam such that 95% of the MM laser beam is provided to port 414B and 5% of the MM laser beam is provided to port 414A. The 95% of the MM laser beam provided to port 414B is provided via MM optical fiber 412D to first beam dump 410. As shown on MM optical fiber 412D as a single headed arrow, first beam dump 410 does not reflect any laser light back to MM 2X2 beam splitter 404. The 5% of the MM laser beam provided to port 414A is provided, via MM optical fiber 412A, to MM laser diode 402. The 5% of the laser light reflected from OFM 406 is used to lock the wavelength of MM light generated by MM laser diode 402. The light reflected from OFM 406 is substantially 'feedback' provided to MM laser diode 402 to stabilize its wavelength. MM laser diode 402 provides its wavelength stabilized MM laser light to port 414A via MM optical fiber 412A, as shown by the double headed arrow on MM optical fiber 412A. MM 2X2 beam splitter 404 receives the MM laser light from MM laser diode 402 and splits the received light such that 95% of the MM laser light is provided as MM laser light to MM output 408 via port 414C and MM optical fiber 412B. 5% of the MM laser light is provided to OFM 406 via port 414D and MM optical fiber 412C. The MM laser light which reaches OFM 406 is either transmitted or is reflected back to MM 2X2 beam splitter 404. The laser light provided to MM optical fiber 412B is outputted. As shown, since MM laser diode 402 is a multimode laser diode, then an output 408 of MM optical fiber 412B is a multimode mode laser light. In contrast to the systems of Figures 3A-4B, system 400 wavelength stabilizes a MM laser diode using only MM optical fibers, thereby reducing energy loss in the system since MM laser light does not need to be converted into SM or LMA laser light and SM laser light does not need to be converted into MM laser light.

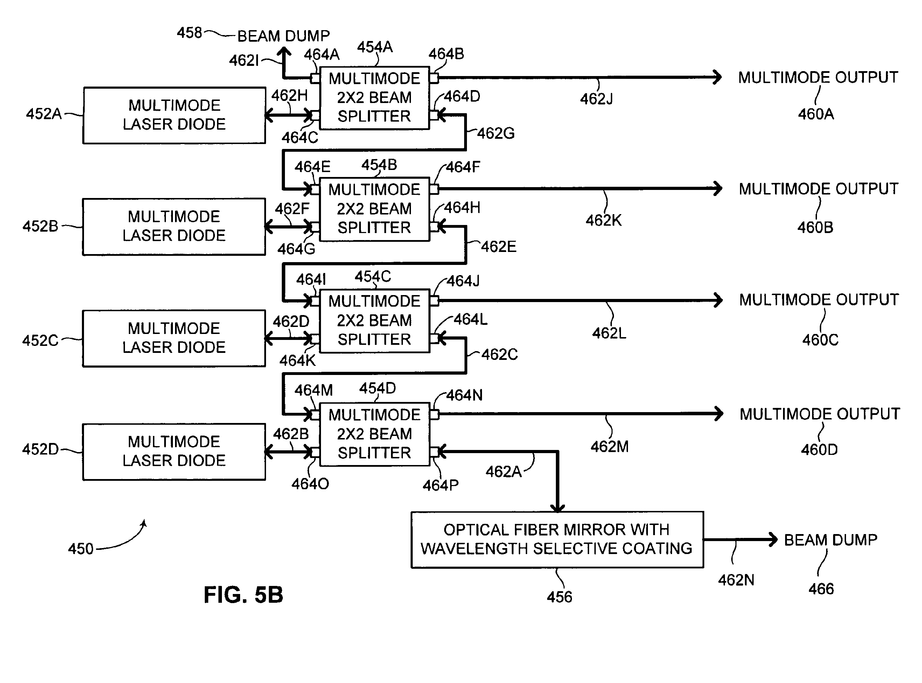

Reference is now made to Figure 5B, which is a schematic illustration of a system for wavelength stabilization in a plurality of multimode laser diodes using a coated optical fiber mirror, generally referenced 450, constructed and operative in accordance with another embodiment of the disclosed technique. System 450 includes a plurality of multimode laser diodes 452A, 452B, 452C and 452D, a plurality of multimode 2X2 beam splitters 454A, 454B, 454C and 454D, an optical fiber mirror (herein abbreviated OFM) 456, a first beam dump 458, a second beam dump 466 and a plurality of multimode optical fibers 462A, 462B, 462C, 462D, 462E, 462F, 462G, 462H, 462I, 462J, 462K, 462L, 462M and 462N. Each one of plurality of multimode (MM) 2X2 beam splitters 454A-454D includes four ports. MM 2X2 beam splitter 454A includes ports 464A, 464B, 464C and 464D. MM 2X2 beam splitter 454B includes ports 464E, 464F, 464G and 464H. MM 2X2 beam splitter 454C includes ports 464I, 464J, 464K and 464L. MM 2X2 beam splitter 454D includes ports 464M, 464N, 4640 and 464P. Each one of plurality of MM 2X2 beam splitters 454A-454D is substantially similar in construction and design to MM 2X2 beam splitter 254A (Figure 3C).

MM laser diode 452A is coupled with port 464C via MM optical fiber 462H. Port 464A is coupled with first beam dump 458 via MM optical fiber 4621. Port 464B is coupled with MM optical fiber 462J, which provides a multimode output 460A of MM laser light. MM laser diode 452B is coupled with port 464G via MM optical fiber 462F. Port 464F is coupled with MM optical fiber 462K, which provides a multimode output 460B of MM laser light. MM laser diode 452C is coupled with port 464K via MM optical fiber 462D. Port 464J is coupled with MM optical fiber 462L, which provides a multimode output 460C of MM laser light. MM laser diode 452D is coupled with port 4640 via MM optical fiber 462B. Port 464N is coupled with MM optical fiber 462M, which provides a multimode output 460D of MM laser light. Port 464P is coupled with MM optical fiber 462A. Ports 464D and 464E, which are respectively on MM 2X2 beam splitters 454A and 454B, are coupled with MM optical fiber 462G. Ports 464H and 464I, which are respectively on MM 2X2 beam splitters 454B and 454C, are coupled with MM optical fiber 462E. Ports 464L and 464M, which are respectively on MM 2X2 beam splitters 454C and 454D, are coupled with MM optical fiber 462C. OFM 456 is coupled with port 464P via MM optical fiber 462A and with second beam dump 466 via MM optical fiber 462N. It is noted that each of MM optical fiber 462J, 462K, 462L and 462M can be coupled with other elements (not shown) for further processing a laser beam before it is outputted. OFM 456 is constructed having a wavelength selective coating. Laser beams impinging on OFM 456 having a wavelength falling in the range of wavelengths defined by the selective coating are substantially completely reflected, whereas laser beams impinging on OFM 456 having a wavelength falling out of the range of wavelengths defined by the selective coating are substantially transmitted to second beam dump 466. It is also noted that first beam dump 458 and second beam dump 466 are substantially similar to beam dump 162 (Figure 3A). It is furthermore noted that first beam dump 458 and second beam dump 466 are optional components in system 450.

The general flow of laser light in system 450 is depicted by the arrow heads on plurality of MM optical fibers 462A-462N. As mentioned above, the splitting ratio of each of plurality of MM 2X2 beam splitters 454A-454D is such that one output port outputs a majority of the energy of the input laser beam, whereas the other output port outputs a small amount of energy of the input laser beam. In system 450, each one of plurality of MM laser diodes 452A-452D is provided feedback from OFM 456. In general each one of plurality of MM laser diodes 452A-452D can be any type of high power laser diode having a wide bandwidth. Each one of plurality of MM laser diodes 452A-452D can operate in a CW mode or a pulsed mode (provided that the pulse width of light outputted by any one of plurality of MM laser diodes 452A-452D is significantly longer than the time it takes light to travel from MM laser diode 452D to OFM 456 and back to MM laser diode 452D). As described in further detail below, a portion of the light generated by each one of plurality of MM laser diodes 452A-452D is reflected by OFM 456 and used to wavelength stabilize the light generated by each one of plurality of MM laser diodes 452A-452D. In general, each one of plurality of MM laser diodes 452A-452D is constantly being provided with laser light having a stable wavelength, reflected from OFM 456, thereby enabling each one of plurality of MM laser diodes 452A-452D to lock onto the wavelength of the reflected beam of light, whether the reflected light is a continuous beam of light or a pulsed beam of light.

Using system 450, a plurality of MM laser diodes can be wavelength stabilized using an OFM while also reducing energy waste. In system 450, an output and an input of each MM 2X2 beam splitter is daisy-chained, as explained in further detail below, such that only a single beam dump is required. It is noted that even though only four MM laser diodes are shown and described in Figure 5B, the laser setup in Figure 5B can be easily modified by a worker skilled in the art to accommodate a plurality of MM laser diodes being wavelength stabilized by a single OFM.

Plurality of MM laser diodes 452A-452D are wavelength stabilized as follows. Plurality of MM laser diodes 452A-452D generate MM laser light having a wide bandwidth. Each one of MM laser diodes 452A-452D is operated simultaneously. MM laser diode 452D provides the MM laser light to port 4640 of MM 2X2 beam splitter 454D via MM optical fiber 462B. MM 2X2 beam splitter 454D splits the received laser beam such that 95% of the laser beam is provided to port 464N and 5% of the laser beam is provided to port 464P. MM laser diode 452C provides the MM laser light to port 464K of MM 2X2 beam splitter 454C via MM optical fiber 462D. MM 2X2 beam splitter 454C splits the received laser beam such that 95% of the laser beam is provided to port 464J and 5% of the laser beam is provided to port 464L. MM laser diode 452B provides the MM laser light to port 464G of MM 2X2 beam splitter 454B via MM optical fiber 462F. MM 2X2 beam splitter 454B splits the received laser beam such that 95% of the laser beam is provided to port 464F and 5% of the laser beam is provided to port 464H. MM laser diode 452A provides the MM laser light to port 464C of MM 2X2 beam splitter 454A via MM optical fiber 462H. MM 2X2 beam splitter 454A splits the received laser beam such that 95% of the laser beam is provided to port 464B and 5% of the laser beam is provided to port 464D.

The 5% of the laser beam provided to port 464P is provided via MM optical fiber 462A to OFM 456. The 5% of the laser beam provided to port 464L is provided to port 464M of MM 2X2 beam splitter 454D. The 5% of the laser beam provided to port 464H is provided to port 4641 of MM 2X2 beam splitter 454C. The 5% of the laser beam provided to port 464D is provided to port 464E of MM 2X2 beam splitter 454B. The 5% of the MM laser beam provided by MM 2X2 beam splitters 454A, 454B and 454C to each of ports 464D, 464H and 464L respectively, is subsequently split, such that a first portion of the laser beam is outputted via one of MM optical fibers 462K, 462L or 462M, and a second portion of the laser beam is transferred eventually to MM 2X2 beam splitter 454D, which transfers the laser beam to MM optical fiber 462A. OFM 456 substantially completely reflects the portion of the laser light received which is in the range of the selective coating back to port 464P, while transmitting substantially all the received laser light at other wavelengths to second beam dump 466. As shown on MM optical fiber 462N as a single headed arrow, second beam dump 466 does not reflect any laser light back to OFM 456.

The laser light reflected by OFM 456 is provided via MM optical fiber 462A to port 464P of MM 2X2 beam splitter 454D. MM 2X2 beam splitter 454D splits the received laser beam such that 95% of the laser beam is provided to port 464M and 5% of the laser beam is provided to port 4640. The 5% of the laser beam provided to port 4640 is provided to MM laser diode 452D, in order to wavelength stabilize it. The 95% of the laser beam provided to port 464M is provided via MM optical fiber 462C to port 464L of MM 2X2 beam splitter 454C. The 95% of the laser beam provided to port 464L is now split by MM 2X2 beam splitter 454C, such that 95% of the received laser beam (∼90% of the reflected laser beam received from OFM 456) is provided to port 4641 and 5% of the received laser beam (∼4.8% of the reflected laser beam received from OFM 456) is provided to port 464K. The 5% of the laser beam provided to port 464K is provided to MM laser diode 452C in order to wavelength stabilize it. The 95% of the laser beam provided to port 4641 is provided via MM optical fiber 462E to port 464H of MM 2X2 beam splitter 454B. The 95% of the laser beam provided to port 464H is now split by MM 2X2 beam splitter 454B, such that 95% of the received laser beam (∼86% of the reflected laser beam received from OFM 456) is provided to port 464E and 5% of the received laser beam (∼4.5% of the reflected laser beam received from OFM 456) is provided to port 464G. The 5% of the laser beam provided to port 464G is provided to MM laser diode 452B in order to wavelength stabilize it. The 95% of the laser beam provided to port 464E is provided via MM optical fiber 462G to port 464D of MM 2X2 beam splitter 454A. The 95% of the laser beam provided to port 464D is now split by MM 2X2 beam splitter 454A, such that 95% of the received laser beam (∼81% of the reflected laser beam received from OFM 456) is provided to port 464A and 5% of the received laser beam (∼4.3% of the reflected laser beam received from OFM 456) is provided to port 464C. The 5% of the laser beam provided to port 464C is provided to MM laser diode 452A in order to wavelength stabilize it. The 95% of the laser beam provided to port 464A is provided via MM optical fiber 462A to first beam dump 458. As shown in Figure 5B, due to the configuration of ports 464M, 464L, 464I, 464H, 464E and 464D, MM 2X2 beam splitters 454A-454D are substantially daisy-chained via MM optical fibers 462C, 462E and 462G. As shown on MM optical fiber 462I as a single headed arrow, first beam dump 458 does not reflect any laser light back to MM 2X2 beam splitters 454A.

In system 450, the light reflected from OFM 456 is substantially 'feedback' provided to each one of plurality of MM laser diodes 452A-452D to stabilize its wavelength. Each one of plurality of MM laser diodes 452A-452D provides its wavelength stabilized MM laser light respectively to ports 4640, 464K, 464G and 464C via respective ones of MM optical fibers 462B, 462D, 462F and 462H, as shown by the double headed arrows on MM optical fibers 462B, 462D, 462F and 462H. MM 2X2 beam splitter 454D receives the wavelength stabilized MM laser light from MM laser diode 452D and splits the received light, as per the example mentioned above, such that 95% of the MM laser light is provided as MM laser light to MM output 460D via port 464N and MM optical fiber 462M. MM 2X2 beam splitter 454C receives the wavelength stabilized MM laser light from MM laser diode 452C and splits the received light such that 95% of the MM laser light is provided as MM laser light to MM output 460C via port 464J and MM optical fiber 462L. MM 2X2 beam splitter 454B receives the wavelength stabilized MM laser light from MM laser diode 452B and splits the received light such that 95% of the MM laser light is provided as MM laser light to MM output 460B via port 464F and MM optical fiber 462K. MM 2X2 beam splitter 454A receives the wavelength stabilized MM laser light from MM laser diode 452A and splits the received light such that 95% of the MM laser light is provided as MM laser light to MM output 460A via port 464B and MM optical fiber 462J.

5% of the MM laser light beam provided to MM 2X2 beam splitter 454A from MM laser diode 452A is provided to port 464D, which provides the laser beam to MM 2X2 beam splitter 454B via port 464E. 5% of the MM laser light beam provided to MM 2X2 beam splitter 454B from MM laser diode 452B is provided to port 464H, which provides the laser beam to MM 2X2 beam splitter 454C via port 464I. 5% of the MM laser light beam provided to MM 2X2 beam splitter 454C from MM laser diode 452C is provided to port 464L, which provides the laser beam to MM 2X2 beam splitter 454D via port 464M. 5% of the MM laser light beam provided to MM 2X2 beam splitter 454D from MM laser diode 452D is provided to port 464P, which provides the laser beam to MM optical fiber 462A. The MM laser light which reaches OFM 456 is either transmitted or reflected back to MM optical fiber 462A, as shown by the arrow heads on MM optical fiber 462A. The laser light provided to MM optical fibers 462J, 462K, 462L and 462M is outputted. As shown, since plurality of MM laser diodes 452A-452D are multimode laser diodes, then plurality of outputs 460A-460D of respective ones of MM optical fibers 462J, 462K, 462L and 462M output multimode mode laser light. In contrast to system 350 (Figure 4B), system 450 does not require the use of any SM optical fibers or a SM to MM optical fiber splice to wavelength stabilize a plurality of MM laser diodes.

Reference is now made to Figure 6A, which is another schematic illustration of a system for wavelength stabilization in a multimode laser diode using an optical fiber mirror and a band pass filter, generally referenced 500, constructed and operative in accordance with a further embodiment of the disclosed technique. System 500 includes a multimode laser diode 502, a multimode 2X2 beam splitter 504, a band pass filter (herein abbreviated BPF) 506, an optical fiber mirror (herein abbreviated OFM) 508, a beam dump 512 and multimode optical fibers 514A, 514B, 514C, 514D and 514E. Multimode (MM) 2X2 beam splitter 504 includes four ports, labeled 516A, 516B, 516C and 516D. MM 2X2 beam splitter 504 is substantially similar in construction and design to MM 2X2 beam splitter 154 (Figure 3A). MM laser diode 502 is coupled with port 516A via MM optical fiber 514A. Port 516C is coupled with beam dump 512 via MM optical fiber 514C. Beam dump 512 is substantially similar to beam dump 162 (Figure 3A). Port 516B is coupled with MM optical fiber 514B, which provides a multimode output 510 of MM laser light. Port 516D is coupled with BPF 506 via MM optical fiber 514D. OFM 508 is coupled with BPF 506 via MM optical fiber 514E. BPF 506 enables only selected wavelengths of laser light to pass through, defined by the band pass of the filter of BPF 506. Substantially all other wavelengths of laser light are deflected (or absorbed) out of the beam path by BPF 506, for example by being deflected at a 45 degree angle to the optic axis (not shown) of BPF 506. Laser light deflected by BPF 506 is not provided to OFM 508 and may be provided to another beam dump (not shown). OFM 508 substantially reflects all laser light impinging upon it. It is noted that MM optical fiber 514B can be coupled with other elements (not shown) for further processing a laser beam before it is outputted. It is also noted that beam dump 512 is an optional component in system 500.

The general flow of laser light in system 500 is depicted by the arrow heads on MM optical fibers 514A-514E. As mentioned above, the splitting ratio of MM 2X2 beam splitter 504 is such that one output port outputs a majority of the energy of the input laser beam, whereas the other output port outputs a small amount of energy of the input laser beam. In system 500, MM laser diode 502 is provided feedback from OFM 508. In general, MM laser diode 502 can be any type of high power laser diode having a wide bandwidth. As described in further detail below, a portion of the light generated by MM laser diode 502 is allowed to pass BPF 506, is reflected by OFM and is used to wavelength stabilize the light generated by MM laser diode 502. MM laser diode 502 can operate in a CW mode or a pulsed mode (provided that the pulse width of the light outputted by MM laser diode 502 is longer than the time it takes light to travel from MM laser diode 502 to OFM 508 and back to MM laser diode 502). In general, MM laser diode 502 is constantly being provided with laser light having a stable wavelength, reflected from OFM 508, thereby enabling MM laser diode 502 to lock onto the wavelength of the reflected beam of light when the reflected light is a continuous beam of light.

MM laser diode 502 is wavelength stabilized as follows. MM laser diode 502 generates MM laser light having a wide bandwidth and provides the MM laser light to port 516A of MM 2X2 beam splitter 504 via MM optical fiber 514A. MM 2X2 beam splitter 504 splits the received laser beam such that 95% of the laser beam is provided to port 516B and 5% of the laser beam is provided to port 516D. The 5% of the laser beam provided to port 516D is provided via MM optical fiber 514D to BPF 506. BPF 506 only enables specific wavelengths of laser light to pass through. The specific wavelengths substantially represent narrow bandwidths of laser light. All other laser light is substantially deflected (or absorbed) out of the beam path by BPF 506. For example, BPF 506 may pass substantially all the laser light it receives which has a wavelength between 972 nm and 980 nm to OFM 508, while deflecting substantially all the received laser light at other wavelengths. The laser light which passes BPF 506 is provided via MM optical fiber 514E to OFM 508, which substantially completely reflects the laser light received back to BPF 506. BPF 506 provides the reflected light back to port 516D via MM optical fiber 514D. This is shown by the double headed arrows on MM optical fibers 514D and 514E.

The laser light reflected by OFM 508 is provided via BPF 506 and MM optical fiber 514D to port 516D, which provides the MM laser light to MM 2X2 beam splitter 504. MM 2X2 beam splitter 504 splits the received MM laser beam such that 95% of the MM laser beam is provided to port 516C and 5% of the MM laser beam is provided to port 516A. The 95% of the MM laser beam provided to port 516C is provided via MM optical fiber 514C to beam dump 512. As shown on MM optical fiber 514C as a single headed arrow, beam dump 512 does not reflect any laser light back to MM 2X2 beam splitter 504. The 5% of the MM laser beam provided to port 516A is provided, via MM optical fiber 514A, to MM laser diode 502. The 5% of the laser light reflected from OFM 508 is used to lock the wavelength of MM light generated by MM laser diode 502. The light reflected from OFM 508 is substantially 'feedback' provided to MM laser diode 502 to stabilize its wavelength. MM laser diode 502 provides its wavelength stabilized MM laser light to port 516A via MM optical fiber 514A, as shown by the double headed arrow on MM optical fiber 514A. MM 2X2 beam splitter 504 receives the MM laser light from MM laser diode 502 and splits the received light such that 95% of the MM laser light is provided as MM laser light to MM output 510 via port 516B and MM optical fiber 514B. 5% of the MM laser light is provided to BPF 506 via port 516D and MM optical fiber 514D. The MM laser light which reaches BPF 506 is either deflected or is allowed to pass to OFM 508. The laser light provided to MM optical fiber 514B is outputted. As shown, since MM laser diode 502 is a multimode laser diode, then an output 510 of MM optical fiber 514B is a multimode mode laser light. In contrast to the systems of Figures 3A-4B, system 500 wavelength stabilizes a MM laser diode using only MM optical fibers, thereby reducing energy loss in the system since MM laser light does not need to be converted into SM or LMA laser light and SM laser light does not need to be converted into MM laser light.

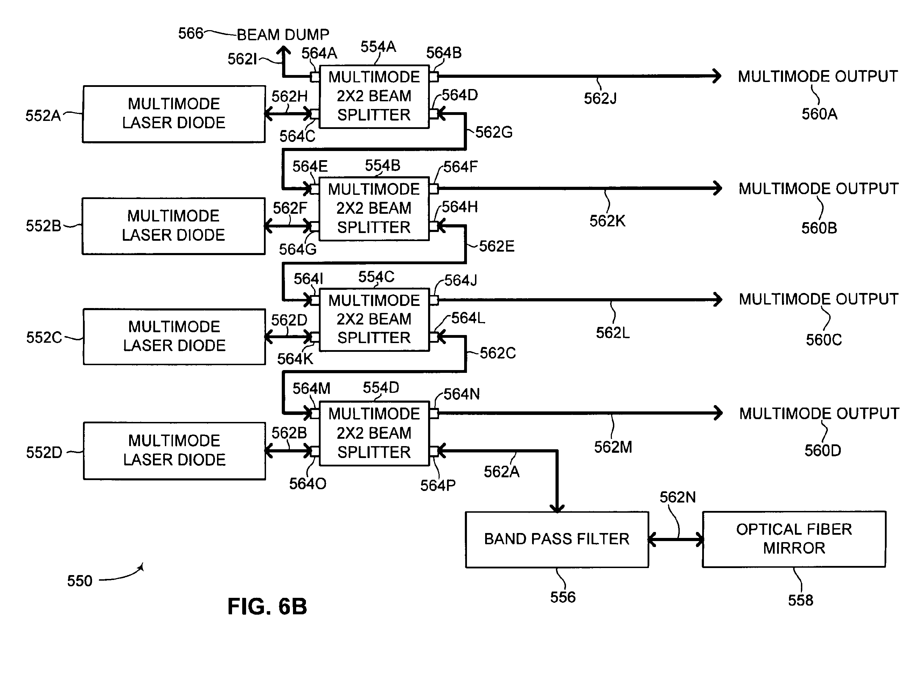

Reference is now made to Figure 6B, which is another schematic illustration of a system for wavelength stabilization in a plurality of multimode laser diodes using an optical fiber mirror and a band pass filter, generally referenced 550, constructed and operative in accordance with another embodiment of the disclosed technique. System 550 includes a plurality of multimode laser diodes 552A, 552B, 552C and 552D, a plurality of multimode 2X2 beam splitters 554A, 554B, 554C and 554D, a band pass filter (herein abbreviated BPF) 556, an optical fiber mirror (herein abbreviated OFM) 558, a beam dump 566 and a plurality of multimode optical fibers 562A, 562B, 562C, 562D, 562E, 562F, 562G, 562H, 562I, 562J, 562K, 562L, 562M and 562N. Each one of plurality of multimode (MM) 2X2 beam splitters 554A-554D includes four ports. MM 2X2 beam splitter 554A includes ports 564A, 564B, 564C and 564D. MM 2X2 beam splitter 554B includes ports 564E, 564F, 564G and 564H. MM 2X2 beam splitter 554C includes ports 5641, 564J, 564K and 564L. MM 2X2 beam splitter 554D includes ports 564M, 564N, 5640 and 564P. Each one of plurality of MM 2X2 beam splitters 554A-554D is substantially similar in construction and design to MM 2X2 beam splitter 254A (Figure 3C).

MM laser diode 552A is coupled with port 564C via MM optical fiber 562H. Port 564A is coupled with beam dump 566 via MM optical fiber 5621. Port 564B is coupled with MM optical fiber 562J, which provides a multimode output 560A of MM laser light. MM laser diode 552B is coupled with port 564G via MM optical fiber 562F. Port 564F is coupled with MM optical fiber 562K, which provides a multimode output 560B of MM laser light. MM laser diode 552C is coupled with port 564K via MM optical fiber 562D. Port 564J is coupled with MM optical fiber 562L, which provides a multimode output 560C of MM laser light. MM laser diode 552D is coupled with port 5640 via MM optical fiber 562B. Port 564N is coupled with MM optical fiber 562M, which provides a multimode output 560D of MM laser light. Port 564P is coupled with MM optical fiber 562A. Ports 564D and 564E, which are respectively on MM 2X2 beam splitters 554A and 554B, are coupled with MM optical fiber 562G. Ports 564H and 5641, which are respectively on MM 2X2 beam splitters 554B and 554C, are coupled with MM optical fiber 562E. Ports 564L and 564M, which are respectively on MM 2X2 beam splitters 554C and 554D, are coupled with MM optical fiber 562C. BPF 556 is coupled with port 564P via MM optical fiber 562A and with OFM 558 via MM optical fiber 562N. It is noted that each of MM optical fiber 562J, 562K, 562L and 562M can be coupled with other elements (not shown) for further processing a laser beam before it is outputted. BPF 556 enables only selected wavelengths of laser light to pass through, defined by the band pass of the filter of BPF 556. Substantially all other wavelengths of laser light are deflected (or absorbed) out of the beam path by BPF 556, for example, by being deflected at a 45 degree angle to the optic axis (not shown) of BPF 556. The deflected laser light may be provided to another beam dump (not shown). OFM 558 substantially reflects all laser light impinging upon it. It is also noted that beam dump 566 is substantially similar to beam dump 162 (Figure 3A). It is furthermore noted that beam dump 566 is an optional component in system 550.

The general flow of laser light in system 550 is depicted by the arrow heads on plurality of MM optical fibers 562A-562N. As mentioned above, the splitting ratio of each of plurality of MM 2X2 beam splitters 554A-554D is such that one output port outputs a majority of the energy of the input laser beam, whereas the other output port outputs a small amount of energy of the input laser beam. In system 550, each one of plurality of MM laser diodes 552A-552D is provided feedback from OFM 558. In general each one of plurality of MM laser diodes 552A-552D can be any type of high power laser diode having a wide bandwidth. Each one of plurality of MM laser diodes 552A-552D can operate in a CW mode or a pulsed mode (provided that the pulse width of the light outputted by any one of plurality of MM laser diodes 552-552D is significantly longer than the time it takes light to travel from MM laser diode 552D to OFM 558 and back to MM laser diode 552D). As described in further detail below, a portion of the light generated by each one of plurality of MM laser diodes 552A-552D is reflected by OFM 558 and used to wavelength stabilize the light generated by each one of plurality of MM laser diodes 552A-552D. In general, each one of plurality of MM laser diodes 552A-552D is constantly being provided with laser light having a stable wavelength, reflected from OFM 558, thereby enabling each one of plurality of MM laser diodes 552A-552D to lock onto the wavelength of the reflected beam of light whether the reflected light is a continuous beam of light or a pulsed beam of light.

Using system 550, a plurality of MM laser diodes can be wavelength stabilized using an OFM while also reducing energy waste. In system 550, an output and an input of each MM 2X2 beam splitter is daisy-chained, as explained in further detail below, such that only a single beam dump is required. It is noted that even though only four MM laser diodes are shown and described in Figure 6B, the laser setup in Figure 6B can be easily modified by a worker skilled in the art to accommodate a plurality of MM laser diodes being wavelength stabilized by a single OFM.

Plurality of MM laser diodes 552A-552D are wavelength stabilized as follows. Plurality of MM laser diodes 552A-552D generate MM laser light having a wide bandwidth. Each one of MM laser diodes 552A-552D is operated simultaneously. MM laser diode 552D provides the MM laser light to port 5640 of MM 2X2 beam splitter 554D via MM optical fiber 562B. MM 2X2 beam splitter 554D splits the received laser beam such that 95% of the laser beam is provided to port 564N and 5% of the laser beam is provided to port 564P. MM laser diode 552C provides the MM laser light to port 564K of MM 2X2 beam splitter 554C via MM optical fiber 562D. MM 2X2 beam splitter 554C splits the received laser beam such that 95% of the laser beam is provided to port 564J and 5% of the laser beam is provided to port 564L. MM laser diode 552B provides the MM laser light to port 564G of MM 2X2 beam splitter 554B via MM optical fiber 562F. MM 2X2 beam splitter 554B splits the received laser beam such that 95% of the laser beam is provided to port 564F and 5% of the laser beam is provided to port 564H. MM laser diode 552A provides the MM laser light to port 564C of MM 2X2 beam splitter 554A via MM optical fiber 562H. MM 2X2 beam splitter 554A splits the received laser beam such that 95% of the laser beam is provided to port 564B and 5% of the laser beam is provided to port 564D.

The 5% of the laser beam provided to port 564P is provided via MM optical fiber 562A to BPF 556. The 5% of the laser beam provided to port 564L is provided to port 564M of MM 2X2 beam splitter 554D. The 5% of the laser beam provided to port 564H is provided to port 564I of MM 2X2 beam splitter 554C. The 5% of the laser beam provided to port 564D is provided to port 564E of MM 2X2 beam splitter 554B. The 5% of the MM laser beam provided by MM 2X2 beam splitters 554A, 554B and 554C to each of ports 564D, 564H and 564L respectively, is subsequently split, such that a first portion of the laser beam is outputted via one of MM optical fibers 562K, 562L or 562M, and a second portion of the laser beam is transferred eventually to MM 2X2 beam splitter 554D, which transfers the laser beam to MM optical fiber 562A to BPF 556. BPF 556 only enables specific wavelengths of laser light to pass through. The specific wavelengths substantially represent narrow bandwidths of laser light. All other laser light is substantially deflected (or absorbed) by BPF 556. The laser light which passes BPF 556 is provided via MM optical fiber 562N to OFM 558, which substantially completely reflects the laser light received back to BPF 556. BPF 556 provides the reflected light back to port 564P via MM optical fiber 562A. This is shown by the double headed arrows on MM optical fibers 562A and 562N.

The laser light reflected by OFM 558 is provided via BPF 556 and MM optical fiber 562A to port 564P of MM 2X2 beam splitter 554D. MM 2X2 beam splitter 554D splits the received laser beam such that 95% of the laser beam is provided to port 564M and 5% of the laser beam is provided to port 5640. The 5% of the laser beam provided to port 5640 is provided to MM laser diode 552D, in order to wavelength stabilize it. The 95% of the laser beam provided to port 564M is provided via MM optical fiber 562C to port 564L of MM 2X2 beam splitter 554C. The 95% of the laser beam provided to port 564L is now split by MM 2X2 beam splitter 554C, such that 95% of the received laser beam (∼90% of the reflected laser beam received from OFM 558 and BPF 556) is provided to port 5641 and 5% of the received laser beam (∼4.8% of the reflected laser beam received from OFM 558 and BPF 556) is provided to port 564K. The 5% of the laser beam provided to port 564K is provided to MM laser diode 552C, in order to wavelength stabilize it. The 95% of the laser beam provided to port 564I is provided via MM optical fiber 562E to port 564H of MM 2X2 beam splitter 554B. The 95% of the laser beam provided to port 564H is now split by MM 2X2 beam splitter 554B, such that 95% of the received laser beam (∼86% of the reflected laser beam received from OFM 558 and BPF 556) is provided to port 564E and 5% of the received laser beam (∼4.5% of the reflected laser beam received from OFM 558 and BPF 556) is provided to port 564G. The 5% of the laser beam provided to port 564G is provided to MM laser diode 552B, in order to wavelength stabilize it. The 95% of the laser beam provided to port 564E is provided via MM optical fiber 562G to port 564D of MM 2X2 beam splitter 554A. The 95% of the laser beam provided to port 564D is now split by MM 2X2 beam splitter 554A, such that 95% of the received laser beam (∼81% of the reflected laser beam received from OFM 558 and BPF 556) is provided to port 564A and 5% of the received laser beam (∼4.3% of the reflected laser beam received from OFM 558 and BPF 556) is provided to port 564C. The 5% of the laser beam provided to port 564C is provided to MM laser diode 552A, in order to wavelength stabilize it. The 95% of the laser beam provided to port 564A is provided via MM optical fiber 562A to beam dump 566. As shown in Figure 5B, due to the configuration of ports 564M, 564L, 564I, 564H, 564E and 564D, MM 2X2 beam splitters 554A-554D are substantially daisy-chained via MM optical fibers 562C, 562E and 562G. As shown on MM optical fiber 562I as a single headed arrow, beam dump 566 does not reflect any laser light back to MM 2X2 beam splitters 554A.

In system 550, the light reflected from OFM 558 via BPF 556 is substantially 'feedback' provided to each one of plurality of MM laser diodes 552A-552D to stabilize its wavelength. Each one of plurality of MM laser diodes 552A-552D provides its wavelength stabilized MM laser light respectively to ports 5640, 564K, 564G and 564C via respective ones of MM optical fibers 562B, 562D, 562F and 562H, as shown by the double headed arrows on MM optical fibers 562B, 562D, 562F and 562H. MM 2X2 beam splitter 554D receives the wavelength stabilized MM laser light from MM laser diode 552D and splits the received light such that 95% of the MM laser light is provided as MM laser light to MM output 560D via port 564N and MM optical fiber 562M. MM 2X2 beam splitter 554C receives the wavelength stabilized MM laser light from MM laser diode 552C and splits the received light such that 95% of the MM laser light is provided as MM laser light to MM output 560C via port 564J and MM optical fiber 562L. MM 2X2 beam splitter 554B receives the wavelength stabilized MM laser light from MM laser diode 552B and splits the received light such that 95% of the MM laser light is provided as MM laser light to MM output 560B via port 564F and MM optical fiber 562K. MM 2X2 beam splitter 554A receives the wavelength stabilized MM laser light from MM laser diode 552A and splits the received light such that 95% of the MM laser light is provided as MM laser light to MM output 560A via port 564B and MM optical fiber 562J.

5% of the MM laser light beam provided to MM 2X2 beam splitter 554A from MM laser diode 552A is provided to port 564D, which provides the laser beam to MM 2X2 beam splitter 554B via port 564E. 5% of the MM laser light beam provided to MM 2X2 beam splitter 554B from MM laser diode 552B is provided to port 564H, which provides the laser beam to MM 2X2 beam splitter 554C via port 564I. 5% of the MM laser light beam provided to MM 2X2 beam splitter 554C from MM laser diode 552C is provided to port 564L, which provides the laser beam to MM 2X2 beam splitter 554D via port 564M. 5% of the MM laser light beam provided to MM 2X2 beam splitter 554D from MM laser diode 552D is provided to port 564P, which provides the laser beam to MM optical fiber 562A. The MM laser light which reaches BPF 556 is either deflected (or absorbed) or passed to OFM 558, which reflects the laser light back to BPF 556 back to MM optical fiber 562A, as shown by the arrow heads on MM optical fibers 562A and 562N. The laser light provided to MM optical fibers 562J, 562K, 562L and 562M is outputted. As shown, since plurality of MM laser diodes 552A-552D are multimode laser diodes, then plurality of outputs 560A-560D of respective ones of MM optical fibers 562J, 562K, 562L and 562M output multimode mode laser light. In contrast to system 350 (Figure 4B), system 550 does not require the use of any SM optical fibers or a SM to MM optical fiber splice to wavelength stabilize a plurality of MM laser diodes.

It is noted that each of HRFBG 306 (Figure 4A), HRFBG 356 (Figure 4B), OFM 406 (Figure 5A), OFM 456 (Figure 5B), BPF 506 and OFM 508 (both from Figure 6A) and BPF 556 and OFM 558 (both from Figure 6B) represent different types of wavelength selective mirrors which are used in the wavelength stabilization systems of Figures 4A-6B. Each of these types of wavelength selective mirrors reflects laser light in a specific narrow bandwidth, which is stable, back to a wide bandwidth high power multimode laser diode, as feedback. The laser light which is reflected back to the high power multimode laser diode is used to stabilize the wavelength of the high power multimode laser diode.

In general, the wavelength stabilization laser diodes setups according to the disclosed technique can be used for various purposes. For example, the system shown in Figure 2 can be used for pumping a fiber laser at an efficient wavelength, cost effectively, as described herein. Fiber lasers using ytterbium-doped fibers are very common in various industries. The pump laser in such a fiber laser can be pumped at a wavelength of between 910-920 nm or 974-978 nm. Pumping at between 974-978 nm is substantially more efficient since the ytterbium-doped fiber can absorb three times the amount of energy as compared to pumping at between 910-920 nm. In addition, since the ytterbium-doped fiber absorbs three times the amount of energy at a wavelength of between 974-978 nm, only a third of the length of fiber is required to absorb the same amount of energy if the pump laser is pumped at between 910-920 nm, a difference which can significantly affect the cost of such a fiber laser. In addition, shorter fiber lengths in fiber lasers can increase the operational quality of the fiber laser. At the same time, pumping the pump laser of such a fiber laser at between 974-978 nm is significantly harder than pumping the pump laser of such a fiber laser at between 910-920 nm, since the bandwidth of the gain of an ytterbium-doped fiber is substantially wide at between 910-920 nm and substantially narrow at between 974-978 nm. In prior art systems, such ytterbium-doped fiber lasers can be wavelength stabilized at between 974-978 nm yet not cost effectively. In such prior art systems, a laser diode used to wavelength stabilize the fiber laser at between 974-978 nm generates a substantial amount of heat and requires significant cooling to maintain the specific wavelength range of between 974-978 nm in the laser diode. Increases in the temperature of the laser diode can cause a shift in the wavelength of light outputted by the laser diode. As a rule of thumb, for each watt of power desired to be outputted by the fiber laser, an additional watt of power is required to cool the laser diode, in order to prevent a shift in its outputted wavelength. According to the disclosed technique, the output of system 100 (Figure 2), configured to output a wavelength stabilized SM laser beam at between 975-977 nm, can be used to wavelength stabilize an ytterbium-doped fiber laser at between 975-977 nm (i.e., the efficient wavelength range for pumping such a fiber laser) cost effectively, since no cooling elements or components are required of system 100 for generating a wavelength stabilized SM laser beam at any particular wavelength.

In addition, output 116 (Figure 2) of system 100, which is a single mode laser beam output, can also be used as a seed for a fiber laser. First single mode laser diode 102 (Figure 2) can be adjusted to output a single mode laser beam having a different possible range in terms of wavelengths for seeding different types of fiber lasers. If first single mode laser diode 102 is adjusted to output a single mode laser beam having a wavelength ranging from 1060-1080 nm then output 116 can be used to seed an ytterbium-based fiber laser. If first single mode laser diode 102 is adjusted to output a single mode laser beam having a wavelength ranging from 1540-1560 nm then output 116 can be used to seed an erbium-based fiber laser. And if first single mode laser diode 102 is adjusted to output a single mode laser beam having a wavelength ranging from 1900-2100 nm then output 116 can be used to seed a thulium-based fiber laser.

As another example, the systems shown in Figures 3A-6B can be used as oscillators or seed lasers in a chain of slave laser amplifiers. The MM wavelength stabilized laser light of any of the systems of Figures 3A-6B can be used to drive and/or wavelength stabilize laser amplifiers in a given laser setup. In addition, the output of the systems shown in Figures 3A-6B, which is a multimode laser beam, can also be used for pumping various types of lasers. For example, the multimode laser diodes in Figures 3A-6B can output a multimode laser beam having a wavelength ranging from 972-980 nm for pumping an ytterbium-based fiber laser. Those same multimode laser diodes can also output a multimode laser beam having a wavelength ranging from 803-813 nm for pumping a solid state laser.

It will be appreciated by persons skilled in the art that the disclosed technique is not limited to what has been particularly shown and described hereinabove. Rather the scope of the disclosed technique is defined only by the claims, which follow.

## Claims

1. System for wavelength stabilization in a multimode (MM) laser diode (LD), comprising:
at least one MM LD, for generating high power MM laser light;
a respective at least one MM 2X2 beam splitter, for each said at least one MM LD, each said respective at least one MM 2X2 beam splitter comprising four ports;
an isolator, for enabling laser light to pass through in only one direction; and
at least one LD, respectively coupled with said isolator, for generating low power laser light,
wherein each said respective at least one MM 2X2 beam splitter is for splitting said generated high power MM laser light and said generated low power laser light, and has a highly asymmetric splitting ratio;
wherein a first port and a third port, of each said respective at least one MM 2X2 beam splitter, each output a significantly high percent of said generated high power MM laser light and said generated low power laser light and a second port and a fourth port, of each said respective at least one MM 2X2 beam splitter, each output a significantly low percent of said generated high power MM laser light and said generated low power laser light;
wherein each said at least one MM LD is respectively coupled with said fourth port of each said respective at least one MM 2X2 beam splitter;
wherein a wavelength of said generated high power MM laser light locks onto a wavelength of said generated low power laser light, thereby wavelength stabilizing said at least one MM LD; and
wherein said first port of each said respective at least one MM 2X2 beam splitter outputs said generated high power MM laser light as wavelength stabilized high power MM laser light.

2. The system according to claim 1, further comprising at least one respective fiber Bragg grating (FBG), for each said at least one LD, respectively coupled between said isolator and said at least one LD, each for respectively wavelength stabilizing said at least one LD, wherein said at least one LD is a single mode (SM) LD having a wide bandwidth.

3. The system according to claim 1, further comprising at least one respective volume Bragg grating (VBG), for each said at least one LD, respectively coupled between said isolator and said at least one LD, each for respectively wavelength stabilizing said at least one LD, wherein said at least one LD is a MM LD having a wide bandwidth.

4. The system according to claim 1, wherein said at least one LD is a master LD having a narrow bandwidth and wherein said at least one MM LD is a slave LD having a wide bandwidth.

5. The system according to claim 1, further comprising a beam dump, coupled with said third port of a first one of said respective at least one MM 2X2 beam splitter,
wherein said isolator is coupled with a single mode (SM) optical fiber;
wherein said second port of said first one of said respective at least one MM 2X2 beam splitter is coupled with a MM optical fiber; and
wherein said SM optical fiber and said MM optical fiber are coupled together with a SM to MM optical fiber splice.

6. The system according to claim 1, wherein said isolator is coupled with a single mode (SM) optical fiber;
wherein said second port of a first one of said respective at least one MM 2X2 beam splitter is coupled with a MM optical fiber;
wherein said SM optical fiber and said MM optical fiber are coupled together with a SM to MM optical fiber splice; and
wherein said first one of said respective at least one MM 2X2 beam splitter is daisy-chained to a second one of said respective at least one MM 2X2 beam splitter by coupling said third port of said first one of said respective at least one MM 2X2 beam splitter to said second port of said second one of said respective at least one MM 2X2 beam splitter and by coupling said third port of said second one of said respective at least one MM 2X2 beam splitter to a beam dump.

7. The system according to claim 1, further comprising a 1XN single mode (SM) beam splitter, for splitting said low power laser light generated by said at least one LD into a plurality of low power laser light beams;
wherein said isolator is coupled with a SM optical fiber to said 1XN SM beam splitter;
wherein said 1XN SM beam splitter is coupled with a plurality of SM optical fibers;
wherein said second port of each one of said respective at least one MM 2X2 beam splitter is coupled with a MM optical fiber;
wherein said plurality of SM optical fibers is respectively coupled with each said MM optical fiber with a SM to MM optical fiber splice; and
wherein said third port of each one of said respective at least one MM 2X2 beam splitter is coupled with a respective beam dump.

8. The system according to claim 1, further comprising a 1XN MM beam splitter, for splitting said low power laser light generated by said at least one LD into a plurality of low power laser light beams;
wherein said isolator is coupled with a MM optical fiber to said 1XN MM beam splitter;
wherein said 1XN MM beam splitter is coupled with said second port of each one of said respective at least one MM 2X2 beam splitter; and
wherein said third port of each one of said respective at least one MM 2X2 beam splitter is coupled with a respective beam dump.

9. System for wavelength stabilization in a multimode (MM) laser diode (LD), comprising:
at least one MM LD, for generating MM laser light;
a respective at least one MM 2X2 beam splitter, for each said at least one MM LD, each said respective at least one MM 2X2 beam splitter comprising four ports, for splitting said generated MM laser light; and
a wavelength selective mirror, for selectively reflecting laser light at a narrow bandwidth,
wherein each said respective at least one MM 2X2 beam splitter has a highly asymmetric splitting ratio;
wherein a first port and a third port, of each said respective at least one MM 2X2 beam splitter, each output a significantly high percent of said generated MM laser light and a second port and a fourth port, of each said respective at least one MM 2X2 beam splitter, each output a significantly low percent of said generated MM laser light;
wherein said wavelength selective mirror is coupled with said second port of a first one of said respective at least one MM 2X2 beam splitter and reflects said generated MM laser light in said narrow bandwidth;
wherein each said at least one MM LD is respectively coupled with said fourth port of each said respective at least one MM 2X2 beam splitter;
wherein a wavelength of said generated MM laser light of each said at least one MM LD locks onto a wavelength of said reflected MM laser light, thereby wavelength stabilizing each said at least one MM LD; and
wherein said first port of each said respective at least one MM 2X2 beam splitter outputs said generated MM laser light as wavelength stabilized MM laser light.

10. The system according to any one of claims 1 and 9, wherein said at least one MM LD can operate in a mode selected from the list consisting of:
a continuous wave (CW) mode; and
a pulsed mode.

11. The system according to claim 9, wherein said third port of said first one of said respective at least one MM 2X2 beam splitter is coupled with a beam dump.

12. The system according to claim 9, wherein a first one of said respective at least one MM 2X2 beam splitter is daisy-chained to a second one of said respective at least one MM 2X2 beam splitter by coupling said third port of said first one of said respective at least one MM 2X2 beam splitter to said second port of said second one of said respective at least one MM 2X2 beam splitter and by coupling said third port of said second one of said respective at least one MM 2X2 beam splitter to a beam dump.

13. The system according to claim 9, wherein said wavelength selective mirror is a high reflection fiber Bragg grating (HRFBG) coupled with a beam dump.

14. The system according to claim 13, wherein said HRFBG is coupled with a single mode (SM) optical fiber, wherein said second port of said first one of said respective at least one MM 2X2 beam splitter is coupled with a MM optical fiber and wherein said SM optical fiber and said MM optical fiber are coupled together with a SM to MM optical fiber splice.

15. The system according to claim 13, wherein said HRFBG is coupled with a large mode area (LMA) optical fiber, wherein said second port of said first one of said respective at least one MM 2X2 beam splitter is coupled with a MM optical fiber and wherein said LMA optical fiber and said MM optical fiber are coupled together with a LMA to MM optical fiber splice.

16. The system according to any one of claims 1 and 9, wherein said four ports of each one of said respective at least one MM 2X2 beam splitter are coupled with MM optical fibers.

17. The system according to any one of claims 4 and 9, wherein said narrow bandwidth is selected from the list consisting of:
972-980 nanometers (nm); and
803-813 nm.

18. The system according to any one of claims 1 and 9, wherein said highly asymmetric splitting ratio can range from 0.1%:99.9% to 25%:75%.
